# EUROPEAN PATENT APPLICATION

(11) **EP 4 568 449 A2**
(43) Date of publication of application: **11.06.2025**
(21) Application number: 24210233.3
(22) Date of filing: 31.10.2024
(51) Int. Cl.: H10D 84/01, H10D 84/85, H10D 30/00, H10D 30/69

(54) **UNIAXIAL DUAL STRAIN IN RIBBONIZED CHANNELS**

(30) Priority: 07.12.2023 US 202318532066
(71) Applicant: INTEL Corporation, Santa Clara, CA 95054 (US)
(72) Inventor: LAVRIC, Daniel S., Portland, OR 97229 (US); PAIK, Marvin Y., Portland, OR 97229 (US); GULER, Leonard P., Hillsboro, OR 97124 (US); MURTHY, Anand, Portland, OR 97229 (US); LINDERT, Nick, Portland, OR 97229 (US); CHOI, Chi-hing, Portland, OR 97229 (US); FARMER, Jason A., Hillsboro, OR 97124 (US)
(74) Representative: HGF

(57) **Abstract**

An integrated circuit structure includes laterally adjacent first and second devices. The first device includes (i) a first source or drain region having a first plurality of portions, (ii) a first plurality of bodies, each body of the first plurality of bodies laterally extending from a corresponding one of the first plurality of portions, and (iii) a first source or drain contact including a first conductive material and coupled to the first plurality of portions. The second device includes (i) a second source or drain region having a second plurality of portions, (ii) a second plurality of bodies, each body of the second plurality of bodies laterally extending from a corresponding one of the second plurality of portions, and (iii) a second source or drain contact coupled to the second plurality of portions and including a second conductive material elementally different from the first conductive material.

## Description

### BACKGROUND

Semiconductor devices are electronic components that exploit the electronic properties of semiconductor materials, such as silicon (Si), germanium (Ge), gallium arsenide (GaAs), and indium phosphide (InP). A field-effect transistor (FET) is a semiconductor device that includes three terminals: a gate, a source, and a drain. A FET uses an electric field applied by the gate to control the electrical conductivity of a channel through which charge carriers (e.g., electrons or holes) flow between the source and drain. In instances where the charge carriers are electrons, the FET is referred to as an n-channel device; and in instances where the charge carriers are holes, the FET is referred to as a p-channel device. Some FETs have a fourth terminal called the body or substrate, which can be used to bias the transistor. In addition, metal-oxide-semiconductor FETs (MOSFETs) include a gate dielectric between the gate and the channel. MOSFETs may also be known as metal-insulator-semiconductor FETs (MISFETSs) or insulated-gate FETs (IGFETs). Complementary MOS (CMOS) structures use a combination of p-channel MOSFET (PMOS) and n-channel MOSFET (NMOS) devices to implement logic gates and other digital circuits.

A FinFET is a MOSFET transistor built around a thin strip of semiconductor material (generally referred to as a fin). The conductive channel of the FinFET device resides on the outer portions of the fin adjacent to the gate dielectric. Specifically, current runs along/within both sidewalls of the fin (sides perpendicular to the substrate surface) as well as along the top of the fin (side parallel to the substrate surface). Because the conductive channel of such configurations includes three different planer regions of the fin (e.g., top and two sides), such a FinFET design is sometimes referred to as a tri-gate transistor. A gate-all-around (GAA) transistor is configured similarly to a fin-based transistor, but instead of a finned channel region, one or more channel bodies such as nanoribbons or nanowires extend between the source and the drain regions. In GAA transistors, the gate material wraps around each such body.

### BRIEF DESCRIPTION OF THE DRAWINGS

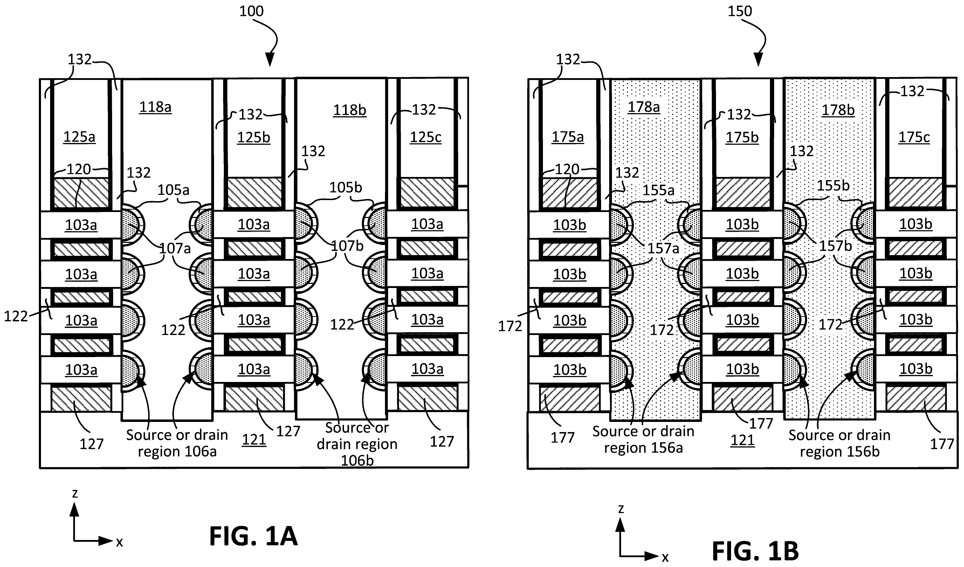

Fig. 1A illustrates a cross-section view of a first integrated circuit device including (i) discontinuous portions of a first source or drain region, (ii) a first source or drain contact coupled to the discontinuous portions of the first source or drain region, and (iii) a first plurality of bodies comprising semiconductor material and forming a channel region of the first integrated circuit device, each of the first plurality of bodies extending laterally from the discontinuous portions of the first source or drain region, wherein the first source or drain contact comprises a first conductive material that facilitates in inducing a first type of strain in one or more of the first plurality of bodies, in accordance with an embodiment of the present disclosure.
Fig. 1B illustrates a cross-section view of a second integrated circuit device, which is on the same integrated circuit die as the first integrated circuit device of Fig. 1A, including (i) discontinuous portions of a second source or drain region, (ii) a second source or drain contact coupled to the discontinuous portions of the second source or drain region, and (iii) a second plurality of bodies comprising semiconductor material and forming a channel region of the second integrated circuit device, each of the second plurality of bodies extending laterally from the discontinuous portions of the second source or drain region, wherein the second source or drain contact comprises a second conductive material that facilitates in inducing a second type of strain in one or more of the second plurality of bodies, in accordance with an embodiment of the present disclosure.
Fig. 1C illustrates a cross-sectional view of an integrated circuit structure comprising the laterally adjacent first integrated circuit device of Fig. 1A and the second integrated circuit device of Fig. 1B, in accordance with an embodiment of the present disclosure.
Fig. 1D illustrates directions of strains induced within the channel region of the first integrated circuit device of Fig. 1A and within the channel region of the second integrated circuit device of Fig. 1B, in accordance with an embodiment of the present disclosure.
Figs. 2A, 2B, and 2C, in combination, illustrate a flowchart depicting a method of forming the example first and second integrated circuit devices of Figs. 1A-1D, in accordance with an embodiment of the present disclosure.
Figs. 3A, 3B, 3C, 3D1, 3D2, 3E1, 3E2, 3F1, 3F2, 3G1, 3G2, 3H1, 3H2, 3I1,3I2, 3J1, 3J2, 3K1, 3K2, 3L1, 3L2, 3M1, 3M2, 3N1, and 3N2 collectively illustrate cross-sectional views of an example integrated circuit structure in various stages of processing in accordance with the methodology of Figs. 2A, 2B, and 2C, in accordance with an embodiment of the present disclosure.
Fig. 4 illustrates a computing system implemented with integrated circuit structures formed using the techniques disclosed herein, in accordance with some embodiments of the present disclosure.

As will be appreciated, the figures are not necessarily drawn to scale or intended to limit the present disclosure to the specific configurations shown. For instance, while some figures generally indicate perfectly straight lines, right angles, and smooth surfaces, an actual implementation of an integrated circuit structure may have less than perfect straight lines, right angles, and some features may have surface topology or otherwise be non-smooth, given real world limitations of the processing equipment and techniques used. Likewise, while the thickness of a given first layer may appear to be similar in thickness to a second layer, in actuality that first layer may be much thinner or thicker than the second layer; same goes for other layer or feature dimensions.

### DETAILED DESCRIPTION

Techniques for inducing strain in ribbonized channel regions of transistors are described. The techniques are particularly useful in gate-all-around (GAA) transistor architectures such as nanowire and nanoribbon transistors, although they may also benefit other transistor topologies such as forksheet transistors or other transistors having epitaxial source and drain regions. Beneficially, compressive strain may be induced within a channel region of a p-channel metal-oxide semiconductor (PMOS) device, and tensile strain may be induced within a channel region of an n-channel metal-oxide semiconductor (NMOS) device. In any such case, the induced strain is uniaxial, in the direction of current flow through the channel region. In one embodiment, each of the PMOS and NMOS devices comprises source and drain regions, where each source or drain region comprises a plurality of discontinuous portions or nubs. A source or drain contacts extends through the source or drain regions, such that the source or drain contact is coupled to each of the plurality of nubs of the corresponding source or drain region. In one embodiment, a first conductive fill material is used for source or drain contacts of the PMOS device, and a second conductive fill material is used for source or drain contacts of the NMOS device, such that the first conductive fill material induces compressive strain on the channel region of the PMOS device, and the second conductive fill material induces tensile strain on the channel region of the NMOS device. In one embodiment, an isolation wall comprising dielectric material is between, and separates a PMOS source or drain contact and an NMOS source or drain contact. The isolation wall facilitates usage of different conductive fill material for the PMOS source or drain contact and the NMOS source or drain contact. Numerous configurations and variations will be apparent in light of this disclosure.

### General Overview

Inducing strain on a channel region of a transistor device tends to improve performance of the transistor device. For example, increased compressive strain on a channel region of a PMOS device improves hole mobility within the channel region, resulting in better performance of the PMOS device. On the other hand, increased tensile strain on a channel region of an NMOS device improves electron mobility within the channel region, resulting in better performance of the NMOS device.

Accordingly, techniques are provided herein to form an integrated circuit structure that includes uniaxially strained channel transistor devices, where source and drain regions and corresponding source and drain contacts of a device are formed to induce an appropriate type of strain on the channel region of the device. Note that an example of the transistor configuration that can benefit from the techniques described herein is a GAA device that includes nanoribbons or nanowires or the like. More generally, the techniques provided herein can benefit any number of transistor or channel configurations used in conjunction with epitaxial source and drain regions, whether the semiconductor bodies making up the channel region are nanowires, nanoribbons, or some other body around which a gate structure can at least partially wrap (such as the nanosheets of a forksheet device).

Continuing with the example of inducing strain on the channel region of a GAA device, conductive material of source and drain contacts of a PMOS device is selected to induce compressive strain of the corresponding channel region of the PMOS device, and conductive material of source and drain contacts of an NMOS device is selected to induce tensile strain of the corresponding channel region of the NMOS device. Example conductive materials for the source and drain contacts of PMOS and NMOS devices, which can respectively induce compressive and tensile strains on the corresponding channel regions, are described below.

In one such embodiment, each source or drain region of a PMOS or an NMOS device has a corresponding plurality of discontinuous portions or nubs (which are also referred to herein as epitaxial nubs or epi nubs). In such an example, the individual portions or nubs making up the source or drain region are not in contact with each other and are thus allowed to maintain their crystalline integrity. In contrast, an epitaxial source or drain region that results from the merging of epitaxial growths from multiple nucleation regions is prone to defects (due to a crash of crystalline growths), and as such may be unable to transfer significant strain to the channel. In contrast, the discontinuous and unmerged portions or nubs of the source or drain regions are allowed to maintain their monocrystalline nature, and have no or reduced crystal defects, and each such portion is able to more satisfactorily transfer strain from the corresponding source or drain contact to a corresponding nanoribbon or other channel body.

Because the source or drain region of a device described below have portions that are discontinuous from each other, the discontinuous portions of the source or drain region occupy a first section of the source or drain trench, and a second section of the source or drain trench is not occupied by the portions of the source or drain region. In one embodiment, the source or drain contact is formed within this second section of the source or drain trench. The source or drain contact, in an example, extends from an upper surface of the source or drain trench to a bottom surface of the source or drain trench, and in some examples may reach or at least in part extend within an underlying substrate. The source or drain contact is coupled to each of the plurality of portions of the corresponding source or drain region.

According to an example, assume a channel region of a nanoribbon based GAA device extends laterally between a source region comprising a plurality of corresponding epi nubs and a drain region comprising a plurality of corresponding epi nubs. Furthermore, a source contact is coupled to the epi nubs of the source region, and a drain contact is coupled to the epi nubs of the drain region. Moreover, each of the source and drain contacts, in an example, extends from an upper surface of the corresponding source or drain trench to a bottom surface of the source or drain trench. Accordingly, each of a plurality of nanoribbons of the channel region (including the lowermost nanoribbon of the channel region) is laterally between the corresponding source contact and the corresponding drain contact. Accordingly, strain from by the source and drain contacts is induced within the nanoribbons (through the monocrystalline epi nubs of the corresponding source or drain region), in a direction parallel to the channel current flow. Thus, each of the nanoribbons, including a lowermost nanoribbon, experience uniaxial strain. In contrast, if the source or drain contact were to not extend all the way to or near a lower surface of the source or drain trench, the lower nanoribbons (such as the lowermost nanoribbon) may not experience uniaxial strain. Allowing the epi nubs to maintain their monocrystalline nature, in conjunction with extending the source or drain contact deep within the source or drain trench, such that the source or drain contact is laterally adjacent to each nanoribbon (e.g., including the lowermost nanoribbon) facilitates the inducement of uniaxial strain in each nanoribbon making up the active channel region.

Furthermore, conductive material of the source and drain contacts of a PMOS device can be selected to induce compressive strain of the corresponding nanoribbons of the PMOS device, and conductive material of source and drain contacts of an NMOS device can be selected to induce tensile strain of the corresponding nanoribbons of the NMOS device. Thus, uniaxial dual strain (e.g., compressive for PMOS nanoribbons, and tensile for NMOS nanoribbons) can be induced in the channel regions of the integrated circuit structure.

In one embodiment, for laterally adjacent PMOS and NMOS devices, a source or drain contact of a PMOS device can be adjacent to a source or drain contact of an NMOS device. In order to have different conductive materials for the PMOS and NMOS source or drain contacts, in an example, the PMOS and the NMOS source or drain contacts are separated by one or more walls of dielectric material, which are also referred to as isolation regions. For example, a source or drain contact is within an area that is at least in part wrapped around by the isolation region walls. The isolation region walls form a tub-like area therewithin, and the source or drain contacts are formed within this at least in part surrounded area. Such isolation walls facilitate usage of a first conductive material for PMOS source or drain contacts, and a second conductive material for laterally NMOS source or drain contacts.

Also described below are methodology for forming the source or drain contacts for the PMOS and NMOS devices using different conductive materials. For example, during at least a part of processing and formation of the PMOS source or drain contacts, the NMOS source or drain contact trenches are masked off. Similarly, during at least a part of processing and formation of the NMOS source or drain contacts, the PMOS source or drain contact trenches are masked off. Example processes for formation of the PMOS and NMOS source or drain contacts using corresponding different conductive materials are described below in further detail. Numerous configurations and variations will be apparent in light of this disclosure.

The use of "group IV semiconductor material" (or "group IV material" or generally, "IV") herein includes at least one group IV element (e.g., silicon, germanium, carbon, tin), such as silicon (Si), germanium (Ge), silicon-germanium (SiGe), and so forth. The use of "group III-V semiconductor material" (or "group III-V material" or generally, "III-V") herein includes at least one group III element (e.g., aluminum, gallium, indium) and at least one group V element (e.g., nitrogen, phosphorus, arsenic, antimony, bismuth), such as gallium arsenide (GaAs), indium gallium arsenide (InGaAs), indium aluminum arsenide (InAlAs), gallium phosphide (GaP), gallium antimonide (GaSb), indium phosphide (InP), gallium nitride (GaN), and so forth. Note that group III may also be known as the boron group or IUPAC group 13, group IV may also be known as the carbon group or IUPAC group 14, and group V may also be known as the nitrogen family or IUPAC group 15, for example.

Materials that are "compositionally different" or "compositionally distinct" as used herein refers to two materials that have different chemical compositions. This compositional difference may be, for instance, by virtue of an element that is in one material but not the other (e.g., SiGe is compositionally different than silicon), or by way of one material having all the same elements as a second material but at least one of those elements is intentionally provided at a different concentration in one material relative to the other material (e.g., SiGe having 70 atomic percent germanium is compositionally different than from SiGe having 25 atomic percent germanium). In addition to such chemical composition diversity, the materials may also have distinct dopants (e.g., gallium and magnesium) or the same dopants but at differing concentrations. In still other embodiments, compositionally distinct materials may further refer to two materials that have different crystallographic orientations. For instance, (110) silicon is compositionally distinct or different from (100) silicon. Creating a stack of different orientations could be accomplished, for instance, with blanket wafer layer transfer. If two materials are elementally different, then one of the material has an element that is not in the other material.

Use of the techniques and structures provided herein may be detectable using tools such as electron microscopy including scanning/transmission electron microscopy (SEM/TEM), scanning transmission electron microscopy (STEM), nano-beam electron diffraction (NBD or NBED), and reflection electron microscopy (REM); composition mapping; x-ray crystallography or diffraction (XRD); energy-dispersive x-ray spectroscopy (EDX); secondary ion mass spectrometry (SIMS); time-of-flight SIMS (ToF-SIMS); atom probe imaging or tomography; local electrode atom probe (LEAP) techniques; 3D tomography; or high resolution physical or chemical analysis, to name a few suitable example analytical tools. For example, such tools may be used to detect an NMOS device having source and drain contacts comprising a first conductive material, and a PMOS device having source and drain contacts comprising a second conductive material, where the first conductive material is different from the second conductive material. Such tools may also detect a channel region of the NMOS device being in tensile strain that is induced by the first conductive material of the source and drain contacts of the NMOS device, and a channel region of the PMOS device being in compressive strain that is induced by the second conductive material of the source and drain contacts of the PMOS device. Such tools may also detect each source or drain region of a PMOS or NMOS device having a corresponding plurality of discontinuous portions or epi nubs, and a corresponding source or drain contact extending within the source or drain trench and coupled to each of the corresponding plurality of discontinuous portions. Numerous configurations and variations will be apparent in light of this disclosure.

### Architecture

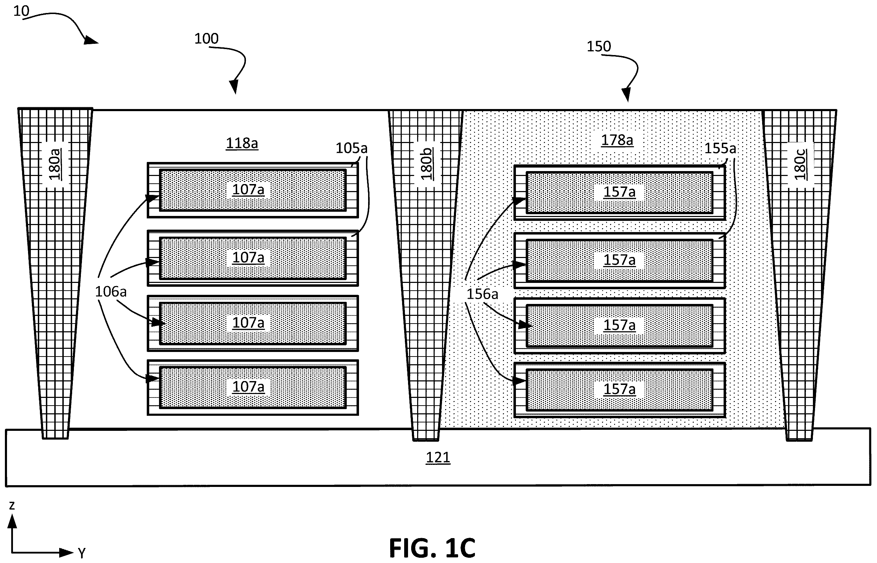

Fig. 1A illustrates a cross-section view of a first integrated circuit device 100 (also referred to herein as "device 100") including (i) discontinuous portions 107a of a first source or drain region 106a, (ii) a first source or drain contact 118a coupled to the discontinuous portions 107a of the first source or drain region 106a, and (iii) a first plurality of bodies 103a comprising semiconductor material and forming a channel region of the first integrated circuit device 100, each of the first plurality of bodies 103a extending laterally from the discontinuous portions 107a of the first source or drain region 106a, wherein the first source or drain contact 118a comprises a first conductive material that facilitates in inducing a first type of strain in one or more of the first plurality of bodies 103a, in accordance with an embodiment of the present disclosure. Fig. 1B illustrates a cross-section view of a second integrated circuit device 150 (also referred to herein as "device 150") including (i) discontinuous portions 157a of a second source or drain region 156a, (ii) a second source or drain contact 178a coupled to the discontinuous portions 157a of the second source or drain region 156a, and (iii) a second plurality of bodies 103b comprising semiconductor material and forming a channel region of the second integrated circuit device 150, each of the second plurality of bodies 103b extending laterally from the discontinuous portions 157a of the second source or drain region 156a, wherein the second source or drain contact 178a comprises a second conductive material that facilitates in inducing a second type of strain in one or more of the second plurality of bodies 103b, in accordance with an embodiment of the present disclosure. Fig. 1C illustrates a cross-sectional view of an integrated circuit structure 10 comprising the laterally adjacent first integrated circuit device 100 of Fig. 1A and the second integrated circuit device 150 of Fig. 1B, in accordance with an embodiment of the present disclosure. The devices 100 and 150 of Figs. 1A, 1B, and 1C will be described below in unison.

As can be seen, the cross-section views of Figs. 1A and 1B are taken parallel to, and through, the fin structure, such that the channel, source, and drain regions are shown. Thus, the cross-section views of Figs. 1A and 1B are gate-cut views centered on the channel regions.

The cross-section view of Fig. 1C is taken parallel to, and through, the source or drain region 106a of the device 100 and the source or drain region 156a of the laterally adjacent device 150. The cross-section view of Fig. 1C is the channel-cut view centered on the source or drain regions. As seen in Fig. 1C, the devices 100 and 150 are laterally adjacent in the Y axis direction.

Referring to Figs. 1A-1C, in an example, the device 100 is an NMOS device and the device 150 is a PMOS device (although in another example, the devices 150 and 100 can respectively be a PMOS and an NMOS device). As describe below, the structures and/or materials of the various source or drain regions and the corresponding source or drain contacts of the PMOS device 150 induce compressive strain on the channel region 103b of the PMOS device 150; and the structures and/or materials of the various source or drain regions and the corresponding source or drain contacts of the NMOS device 100 induce tensile strain on the channel region 103a of the NMOS device 100. Also, increased compressive strain on the channel region of a PMOS device improves hole mobility within the channel region, resulting in better performance of the PMOS device. On the other hand, increased tensile strain on the channel region of an NMOS device improves electron mobility within the channel region, resulting in better performance of the NMOS device. Thus, inducing compressive strain on the channel region 103b of the PMOS device 150 and inducing tensile strain on the channel region 103a of the NMOS device 100 results in improving performance of these devices, as described below.

The semiconductor bodies 103a and 103b included in the channel regions of the devices 100 and 150, respectively, can vary in form, and in some examples described herein are in the form of nanoribbons. In particular, the channel region of the device 100 in this example case includes a first set of four nanoribbons 103a, and the channel region of the device 150 include a second set of four nanoribbons 103b. Other examples may include fewer nanoribbons per channel region (e.g., one or two), or more nanoribbons per channel region (e.g., five or six). Still other embodiments may include other channel configurations, such as one or more nanowires or nanosheets or other semiconductor body. To this end, the present disclosure is not intended to be limited to any particular channel configuration or topology; rather the techniques provided herein can be used in any transistor architecture that uses complementary type of adjacent transistors.

The device configuration includes laterally adjacent devices 100 and 150, separated by an isolation region 180b illustrated in Fig. 1C. For example, each source or drain contacts 118a, 118b, 178a, 178b is separated from an adjacent source or drain contact by a corresponding isolation region 180, such as the isolation region 180b between the source or drain contact 118a of the device 100 and the source or drain contact 178a of the device 160. Each isolation region 180 comprises dielectric material, such as a dielectric diffusion break region that electrically isolates the two devices 100 and 150, and is also referred to as a dielectric material wall (or a wall comprising dielectric material). In an example, the isolation regions 180a, 180b, 180c comprise dielectric material, which may include any number of dielectrics, such as oxides, nitrides, carbides, oxynitrides, oxycarbides, and oxycarbonitrides.

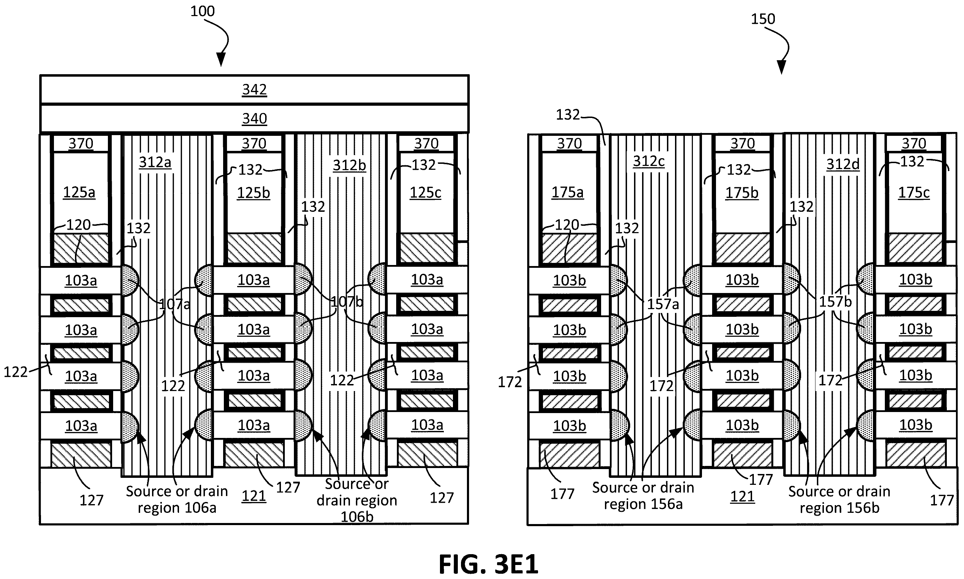

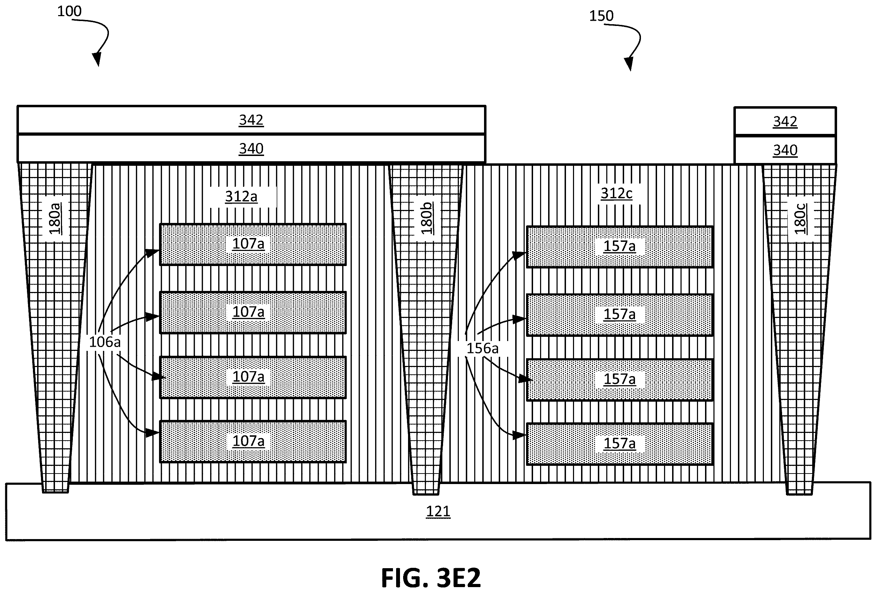

In one embodiment, an isolation region 180 is on more than one side of a source or drain contact, such as the source or drain contact 118a. For example, the isolation region 180 may form at least a partial boundary wall around a source or drain trench, and the portions of the source or drain regions and the corresponding source or drain contact may be formed within this boundary region. Thus, in an example, the isolation region 180 may form a tub like shape, within which a source or drain contact may be formed. As described below, the conductive materials of the source or drain contacts 118a and 178a are elementally and/or compositionally different. The isolation region 180 ensure that when the source or drain contact 178a is formed, the source or drain trench of the source or drain contact 118a can be masked off (e.g., see Figs. 3E1-3J2), and *vice versa.* Thus, the isolation region 180 facilitates use of different conductive materials for two adjacent source or drain contacts of the two devices 100, 150.

Thus, each of the source or drain contacts 118a and 178a are proximal to, or in contact with the isolation region 180. For example, each of the source or drain contacts 118a and 178a is within at most 8 nm, or at most 5 nm, or at most 3 nm, or at most 2 nm from the isolation region 180, or is in contact with the isolation region 180.

In the example of Fig. 1A, the device 100 includes a first source or drain region 106a and a second source or drain region 106a. For ease of identification, it is assumed that the source or drain region 106a is configured as a source region, and the source or drain region 106b is configured as a drain region. Note that in an example, the location of the source and drain regions in a device may be interchanged.

Similarly, in the example of Fig. 1B, the device 150 includes a first source or drain region 156a and a second source or drain region 156b. For ease of identification, it is assumed that the source or drain region 156a is configured as a source region, and the source or drain region 156b is configured as a drain region, although such configuration may be implementation specific.

In the device 100, each of the source region 106a and the drain region 106b is adjacent to a gated channel region on either side. Other embodiments may not have gated channel regions to each side, such as the example case where only the channel region between source region 106a and drain region 106b is present in the device 100. Similarly, in the device 150, each of the source region 156a and the drain region 156b is adjacent to a gated channel region on either side. Other embodiments may not have gated channel regions to each side, such as the example case where only the channel region between source region 156a and drain region 156b is present in the device 150.

In one embodiment, each of the source or drain regions 106a, 106b, 156a, 156b are discontinuous source or drain regions. For example, the source region 106a comprises a plurality of discontinuous portions 107a. For example, each of the portions 107a is coupled to, in contact with, and/or attached to an end of a corresponding nanoribbon 103a. Each portion of a source or drain region is referred to as an epitaxial nub, or simply as epi nub. Each epi nub or portion 107a of the source region 106a is aligned with a corresponding one of the nanoribbons 103a. The portions 107a are discrete portions, e.g., separated vertically and horizontally from each other. In an embodiment, each of the portions 107a of the source region 106a has a faceted or geometrical shape, depending on the crystalline growth. In one embodiment, each portion 107a is monocrystalline, and comprises a single crystal. For example, each portion 107a is grown epitaxially from a corresponding nucleation region of the exposed channel.

Similarly, the drain region 106b of the device 100 comprises a plurality of discontinuous portions 107b, the source region 156a of the device 150 comprises a plurality of discontinuous portions 157a, and the drain region 156b of the device 150 comprises a plurality of discontinuous portions 157b. The geometry of the portions 107b, 157a, 157b will be apparent, based on the above description with respect to the portions 107a of the source region 106a.

In the device 100, three vertical stacks of nanoribbons 103a are illustrated, such as (i) a left vertical stack of nanoribbons 103a (e.g., above which the gate contact 125a is present) extending laterally towards the left and away from the source region 106a, (ii) an intermediate vertical stack of nanoribbons 103a (e.g., above which the gate contact 125b is present) extending laterally between the source region 106a and the drain region 106b, and (iii) aright vertical stack of nanoribbons 103a (e.g., above which the gate contact 125c is present) extending laterally towards the right and away from the drain region 106b. The left stack of nanoribbons 103a may have another source or drain region present on its left side, and similarly, the right stack of nanoribbons 103a may have another source or drain region present on its right side. The intermediate stack of nanoribbons 103a extends between the source region 106a and the drain region 106b. For examples, each nanoribbon 103a of the intermediate stack of the device 100 extends laterally between a corresponding portion 107a of the source region 106a and a corresponding portion 107b of the drain region 106b. Thus, each nanoribbon 103a of the intermediate stack of the device 100 is in contact with corresponding portion 107a of the source region 106a at a first end, and a corresponding portion 107b of the drain region 106b at an opposing second end.

Similarly, in the device 150, three vertical stacks of nanoribbon 103b are illustrated, such as (i) a left vertical stack of nanoribbons 103b (e.g., above which the gate contact 175a is present) extending laterally towards the left away from the source region 156a, (ii) an intermediate vertical stack of nanoribbons 103b (e.g., above which the gate contact 175b is present) extending laterally between the source region 156b and the drain region 156b, and (iii) a right vertical stack of nanoribbons 103b (e.g., above which the gate contact 175c is present) extending laterally towards the right from the drain region 156b. The left stack of nanoribbons 103b may have another source or drain region on its left, and similarly, the right stack of nanoribbons 103b may have another source or drain region present on its right. The intermediate stack of nanoribbons 103b extends between the source region 156a and the drain region 156b. For examples, each nanoribbon 103b of the intermediate stack of the device 150 extends laterally between a corresponding portion 157a of the source region 156a and a corresponding portion 157b of the drain region 156b. Thus, each nanoribbon 103b of the intermediate stack of the device 150 is in contact with corresponding portion 157a of the source region 156a at a first end, and a corresponding portion 157b of the drain region 156b at an opposing second end.

The various portions 107a, 107b, 157a, 157b of the various source and drain regions 106a, 106b, 156a, 156b, respectively, can be any suitable semiconductor material and may include any dopant scheme. As described above, the device 100 is an NMOS device and the device 150 is a PMOS device. In an example, source and drain regions 156a, 156b (e.g., such as the portions 157a, 157b, respectively, of the source and drain regions 156a, 156b) of the PMOS device 150 can be PMOS source and drain regions that include, for example, group IV semiconductor materials such as silicon, germanium, SiGe, germanium tin (GeSn), SiGe alloyed with carbon (SiGe:C). Example p-type dopants include boron, gallium, indium, and aluminum. In an example, source and drain regions 106a, 106b (e.g., such as the portions 107a, 107b, respectively, of the source and drain regions 106a, 106b) of the NMOS device 100 can be NMOS source and drain regions that include, for example, silicon or group III-V semiconductor materials such as two or more of indium, aluminum, arsenic, phosphorus, gallium, and antimony, with some example compounds including but not limited to indium aluminum arsenide, indium arsenide phosphide, indium gallium arsenide, indium gallium arsenide phosphide, gallium antimonide, gallium aluminum antimonide, indium gallium antimonide, or indium gallium phosphide antimonide. In one specific embodiment, PMOS source and drain regions 156a, 156b are boron-doped SiGe, and NMOS source and drain regions 106a, 106b are phosphorus-doped silicon. In a more general sense, the source and drain regions can be any semiconductor material suitable for a given application.

In some cases, individual portions of an epi source or drain region described above may include a multilayer structure, such as a germanium cap on a SiGe body, or a germanium body and a carbon-containing SiGe spacer or liner between the corresponding channel region and that germanium body. In any such cases, a portion of the epi source and drain regions may have a component that is graded in concentration, such as a graded germanium concentration to facilitate lattice matching, or a graded dopant concentration to facilitate low contact resistance. Any number of source and drain configurations can be used as will be appreciated, and the present disclosure is not intended to be limited to any particular such configurations.

As illustrated in Fig. 1A, for the device 100, a source contact 118a extends within the source region 106a, and a drain contact 118b extends within the drain region 106b. The source contact 118a is coupled to the plurality of portions 107a of the source region 106a, and the drain contact 118b is coupled to the plurality of portions 107b of the drain region 106b. In an example, the source contact 118a fully extends through the source region 106a, such that the source contact 118a reaches and is in contact with an underlying substrate 121 on which the devices 100 and/or 150 are formed. For example, a lower portion of the source contact 118a extends at least in part within, or is at least in contact with, the substrate 121. Similarly, the drain contact 118b fully extends through the drain region 106b, such that the drain contact 118b reaches and is in contact with the substrate 121. For example, a lower portion of the drain contact 118b extends at least in part within, or is at least in contact with, the substrate 121. Because the source contact 181a and the drain contact 181b extends to the substrate 121, each of the nanoribbons 103a of the intermediate vertical stack of nanoribbons of the device 100 (e.g., above which the gate contact 125b is present) is laterally between the source contact 118a and the drain contact 118b, including the bottom-most nanoribbon 103a.

Similarly, as illustrated in Fig. 1B, for the device 150, a source contact 178a extends within the source region 156a, and a drain contact 178b extends within the drain region 156b. The source contact 178a is coupled to the plurality of portions 157a of the source region 156a, and the drain contact 178b is coupled to the plurality of portions 157b of the drain region 156b. In an example, the source contact 178a reaches and is in contact with the substrate 121. For example, a lower portion of the source contact 178a extends at least in part within, or is at least in contact with, the substrate 121. Similarly, a lower portion of the drain contact 178b extends at least in part within, or is at least in contact with, the substrate 121. As illustrated, each of the nanoribbons 103b of the intermediate vertical stack of nanoribbons of the device 150 (e.g., above which the gate contact 175b is present) extends laterally between the source contact 178a and the drain contact 178b.

In an example, a conductive lining layer 105 or 155 is between a source or drain contact and a corresponding source or drain region. For example, the conductive lining layer 105a is between each portion 107a of the source region 106a and the source contact 118a; the conductive lining layer 105b is between each portion 107b of the drain region 106b and the drain contact 118b; the conductive lining layer 155a is between each portion 157a of the source region 156a and the source contact 178a; and the conductive lining layer 155b is between each portion 157b of the drain region 156b and the drain contact 178b. In an example, the conductive lining layers 105a, 105b, 155a, 155b are representative of one or more silicide layer(s), germanide layer(s), germanosilicide layer(s), and/or adhesive layer(s) between the conductive source or drain metal contact and the adjacent source or drain region. In an example, the lining layers 105a, 105b, 155a, 155b reduce contact resistance of the source and drain contacts. In an example, the lining layers 105a, 105b, 155a, 155b may be assumed to be a part of the corresponding source or drain contacts.

In one embodiment, the source contact 118a and the drain contact 118b of the device 100 comprise a first conductive fill material, and the source contact 178a and the drain contact 178b of the device 150 comprise a second conductive fill material different from the first conductive material. For example, the conductive fill materials of the source and drain contacts 118a, 118b of the device 100 are compositionally and/or elementally different from the conductive fill materials of the source and drain contacts 178a, 178b of the device 150.

For example, assume that the device 100 is an NMOS device and the device 150 is a PMOS device. In an example, increased compressive strain on nanoribbons 103b of the PMOS device 150 improves hole mobility within the nanoribbons 103b, resulting in better performance of the PMOS device 150. Put differently, if the nanoribbons 103b of the device 150 are compressively strained, the performance of the device 150 improves. On the other hand, increased tensile strain on nanoribbons 103a of the NMOS device 100 improves electron mobility within the nanoribbons 103a, resulting in better performance of the NMOS device 100. Put differently, if the nanoribbons 103a of the device 100 are under tensile strain, the performance of the device 100 improves. In an example, the conductive material of the source and drain contacts 118a, 118b of the NMOS device 100 and the conductive material of the source and drain contacts 178a, 178b of the PMOS device 150 are selected to impart or induce (or facilitate in inducing) appropriate type of strains within nanoribbons of the corresponding devices.

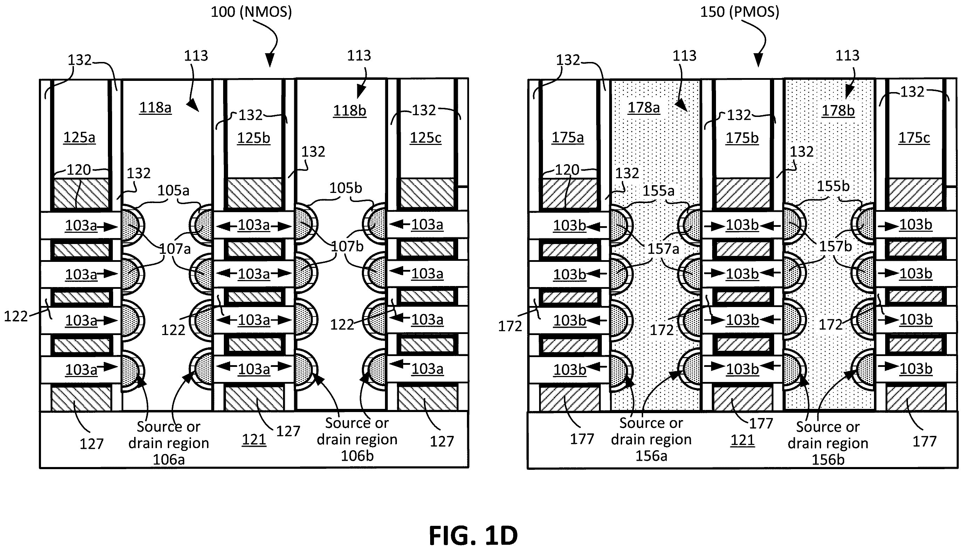

Fig. 1D illustrates directions of strains induced within the channel region 103a of the first integrated circuit device 100 of Fig. 1A and within the channel region 103b of the second integrated circuit device 150 of Fig. 1B, in accordance with an embodiment of the present disclosure. For example, Fig. 1D illustrates using arrows within the nanoribbons 103a, 103b the type of strain induced within the corresponding nanoribbons.

In an example, the conductive material of the source and drain contacts 118a, 118b of the NMOS device 100 is selected such that after deposition of the conductive material of the source and drain contacts 118a, 118b, the conductive material compresses to an extent, thereby imparting tensile strain on the adjacent nanoribbons 103a of the NMOS device 100. Thus, as illustrated in Fig. 1D, each of the nanoribbons 103a aims to expand towards the corresponding source or drain contacts 118a, 118b of the source or drain regions 106a, 106b, respectively, thereby experiencing the tensile strain. Note that the source or drain contacts 118a, 118b extend all the way to the substrate 121, and the source or drain contacts 118a, 118b are able to induce the tensile strain in substantially a direction perpendicular to the height of the source or drain contacts 118a, 118b. Thus, the tensile strain induced within the nanoribbons 103a is uniaxial strain along the direction of the lengths of the nanoribbons 103a.

On the other hand, the conductive material of the source and drain contacts 178a, 178b of the PMOS device 150 is selected such that after deposition of the conductive material of the source and drain contacts 178a, 178b, the conductive material expands to an extent, thereby imparting compressive strain on the adjacent nanoribbons 103b of the PMOS device 150. Thus, as illustrated in Fig. 1D, each of the nanoribbons 103b aims to be compressed away from the corresponding source or drain contacts 178a, 178b of the source or drain regions 156a, 156b, respectively, thereby experiencing the compressive strain. Note that the source or drain contacts 178a, 178b extend all the way to the substrate 121, and the source or drain contacts 178a, 178b are able to induce the compressive strain in substantially a direction perpendicular to the height of the source or drain contacts 178a, 178b. Thus, the compressive strain induced within the nanoribbons 103b is uniaxial strain along the direction of the lengths of the nanoribbons 103a.

In an example, in addition to (or instead of) using an appropriate conductive material for source or drain contacts to tune the strain in the nanoribbons 103, appropriate deposition techniques for depositing the conductive materials of various source or drain contacts can also be used to tune or control the strain in the corresponding nanoribbons. In an example, conductive material for source and/or drain contacts may be deposited using physical vapor deposition (PVD), chemical vapor deposition (CVD) and/or atomic layer deposition (ALD) techniques, and the PVD, CVD, and/or ALD deposition technique can be tuned to tune the amount of tensile or compressive strain within the corresponding nanoribbons. For example, PVD, CDV, and/or ALD process parameters (e.g., reactants used in these deposition techniques, process parameters such as temperature and co-reactants) can be tuned to selectively induce or at least tune the tensile or compressive strain of corresponding nanoribbons.

In one embodiment, conductive materials of the source or drain contacts 118a, 118b, which can impart tensile strain to the nanoribbons 103a of the device 100, include one or more of tungsten (W), cobalt (Co), titanium (Ti), vanadium (V), zirconium (Zr), Niobium (Nb), nickel (Ni), ruthenium (Ru), tantalum (Ta), titanium nitride (TiN), and/or vanadium nitride (VN), for example. For example, titanium nitride deposited using an atomic layer deposition (ALD) process can have a tensile stress in the range of +0.8 to +2 Giga-pascals (GPa). In another example, tungsten deposited using a chemical vapor deposition (CVD) process can have a tensile stress in the range of +1.5 to +2 GPa. In another example, vanadium nitride deposited using an ALD process can have a tensile stress in the range of +1.7 to +2.6 GPa. One or more such relatively high tensile stress materials (such as metals) may induce a relatively high tensile strain within the nanoribbon 103a, such as a tensile strain of at least 2%, or at least 1.8%, or at least 1.5%, or at least 1% within the nanoribbon 103a. In an example, tensile strain induced within the nanoribbon 103a is within a range of 0.8 to 2%, or in a subrange of 1 to 1.5%.

In one embodiment, conductive materials of the source or drain contacts 178a, 178b, which can impart compressive strain to the nanoribbons 103b of the device 150, include molybdenum (Mo), for example. For example, the molybdenum can be processed (e.g., using plasma or other techniques) and the deposition process of molybdenum can be controlled, to fine tune the amount of compressive strain in the nanoribbons 103b. For example, processing and/or deposition of molybdenum can be controlled to achieve a mild compressive stress (about -0.5 GPa), medium compressive stress (about -1 GPa), or high compressive stress (in the range of -2 GPa to -3.5 GPa). The relatively high compressive stress of molybdenum may impart a relatively elevated strain within the nanoribbons 103b, such as a strain of at least 0.8%, or at least 1%, or at least 1.2%, or at least 1.5%, or at least 1.8%, or at least 2%.

Referring again to Figs. 1A-1C, in one embodiment, each of gate structures 122 of the device 100 wraps around each of the nanoribbons 103a in the corresponding channel region. Gate spacers 132 isolates the gate structures 122 from contacting the portions 107a of the source region 106a and the portions 107b of the drain region 106b. In other embodiments, there may be other insulator layers (e.g., interlayer dielectric) that prevent such contact, whether in addition to the gate spaces 132, or in place of the gate spacers 132. In an example, conductive gate contacts 125a, 125b, and 125c provide contacts to respective three gate structures 122 of the device 100.

In one embodiment, each of gate structures 172 of the device 150 wraps around each of the nanoribbons 103b in the corresponding channel region. Gate spacers 132 isolates the gate structures 172 from contacting the portions 157a of the source region 156a and the portions 157b of the drain region 156b. In other embodiments, there may be other insulator layers (e.g., interlayer dielectric) that prevent such contact, whether in addition to the gate spaces 132, or in place of the gate spacers 132. In an example, conductive gate contacts 175a, 175b, and 175c provide contacts to respective three gate structures 172 of the device 101.

Each of gate structures 122, 172 can be formed via gate-first or gate-last processing, and may include any number of suitable gate materials and configurations. In an embodiment, each of the gate structures 122, 172 includes a corresponding gate electrode and a gate dielectric 120 between the gate electrode and the corresponding nanoribbons 103.

In one example the gate spacers 132 may be considered part of the gate structure, whereas in another example the gate spacers 132 may be considered external to the gate structure. Each of the gate structures 122 of the device 100 comprises a corresponding gate electrode 127 and corresponding dielectric material 120. Each of the gate structures 172 of the device 150 comprises a corresponding gate electrode 177 and corresponding dielectric material 120. The gate dielectric material 120 (shown with thick bolded lines) warps around middle section of individual nanoribbons 103 (note that end sections of individual nanoribbons 103 are wrapped around by the gate spacers 132). The gate dielectric material 120 is between individual nanoribbons 103 and corresponding gate electrode, as illustrated. In an example, due to conformal deposition of the gate dielectric material 120, the gate dielectric material 120 may also be on inner sidewalls of the gate spacers 132, as illustrated.

The gate dielectric 120 may include a single material layer or multiple stacked material layers. The gate dielectric may include, for example, any suitable oxide (such as silicon dioxide), high-k dielectric material, and/or any other suitable material as will be apparent in light of this disclosure. Examples of high-k dielectric materials include, for instance, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate, to provide some examples. The high-k dielectric material (e.g., hafnium oxide) may be doped with an element to affect the threshold voltage of the given semiconductor device. According to some embodiments, the doping element used in gate dielectric 120 is lanthanum. In some embodiments, the gate dielectric can be annealed to improve its quality when high-k dielectric material is used. In some embodiments, the gate dielectric 120 includes a first layer (e.g., native oxide of nanoribbons, such as silicon dioxide or germanium oxide or SiGe-oxide) on the nanoribbons, and a second layer of high-k dielectric (e.g., hafnium oxide) on the first layer.

In an example, the gate electrode 127 of the device 100 and the gate electrode 177 of the device 150 may include any sufficiently conductive material, such as a metal or metal alloy. The gate electrodes may include a wide range of materials, such various suitable metals or metal alloys, such as aluminum, tungsten, titanium, tantalum, copper, cobalt, molybdenum, titanium nitride, or tantalum nitride, for example.

In one embodiment, one or more work function materials (not illustrated in Figs. 1A and 1B) may be included around the nanoribbons 103. Note that work function materials are called out separately, but may be considered to be part of the gate electrodes. In this manner, a gate electrode may include multiple layers or components, including one or more work function materials, gate fill material, capping or resistance-reducing material, to name a few examples. In some embodiments, a p-channel device may include a work function metal having titanium, and an n-channel device may include a work function metal having tungsten or aluminum, although other material and combination may also be possible. In some other embodiments, the work function metal may be absent around one or more nanoribbons 103. In still other embodiments, there may be insufficient room for any gate fill material, after deposition of work function material (i.e., a given gate electrode may be all work function material and no fill material). Numerous gate structure configurations can be used along with the techniques provided herein, and the present disclosure is not intended to be limited to any particular such configurations.

The semiconductor bodies 103a, 103b of the channel regions of the devices 100, 150, respectively, which in this case are nanoribbons, can be any number of semiconductor materials as well, such as group IV material (e.g., silicon, germanium, or SiGe) or group III-V materials (e.g., indium gallium arsenide). The semiconductor bodies 103 may be lightly doped, or undoped, and may be shaped or sculpted during the gate formation process, according to some embodiments. In some cases, semiconductor bodies 103 may be a multilayer structure, such as a SiGe body cladded with germanium, or a silicon body cladded with SiGe. Any number of channel configurations can be used.

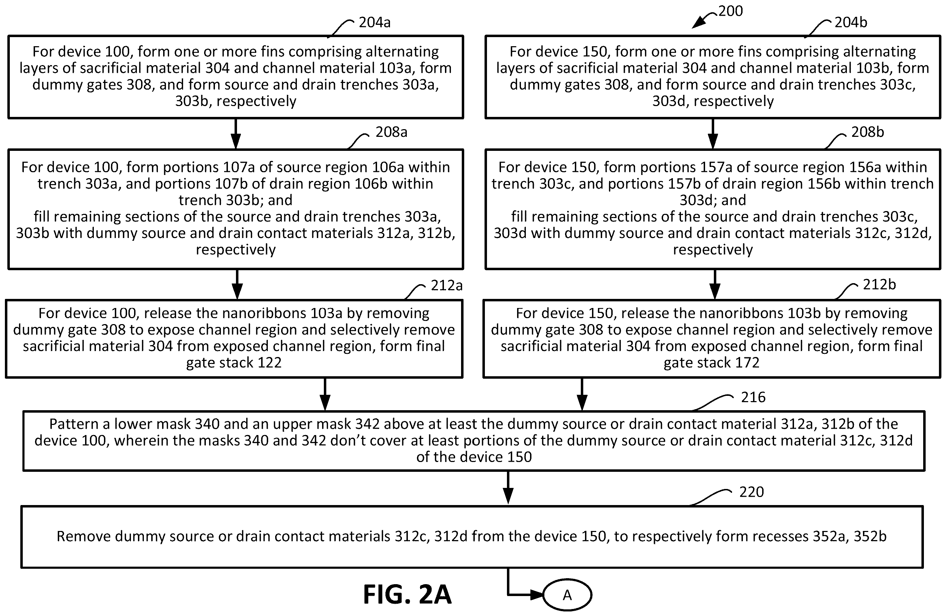

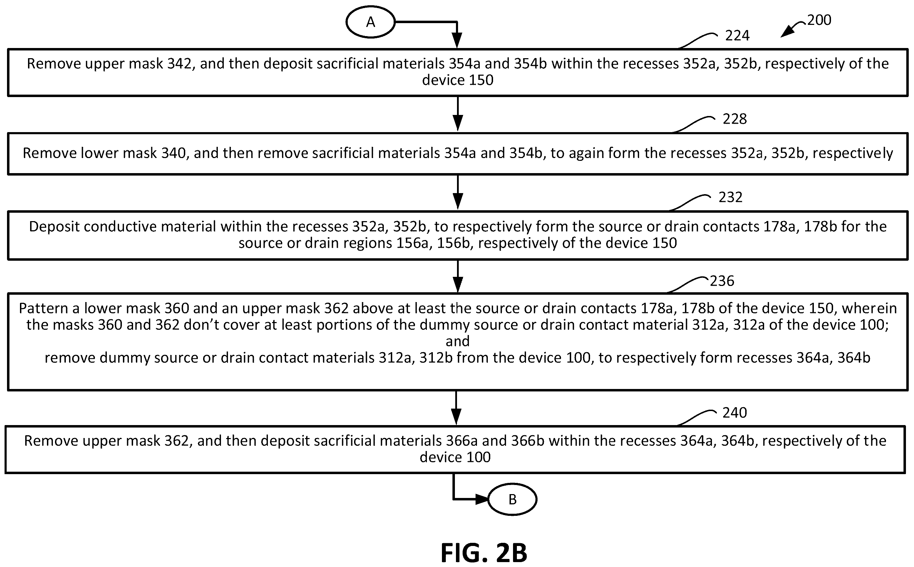

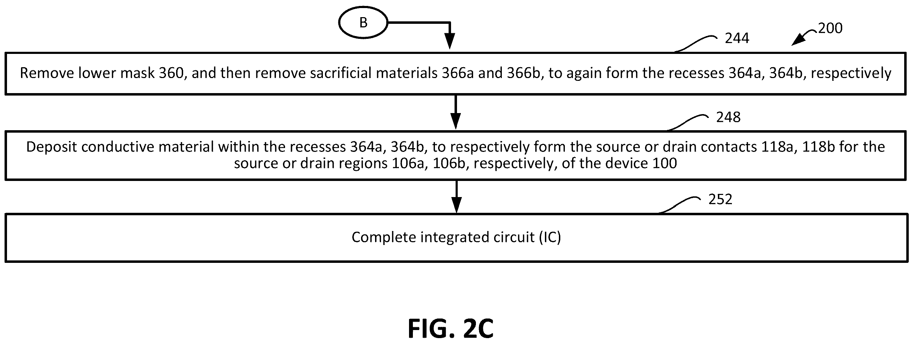

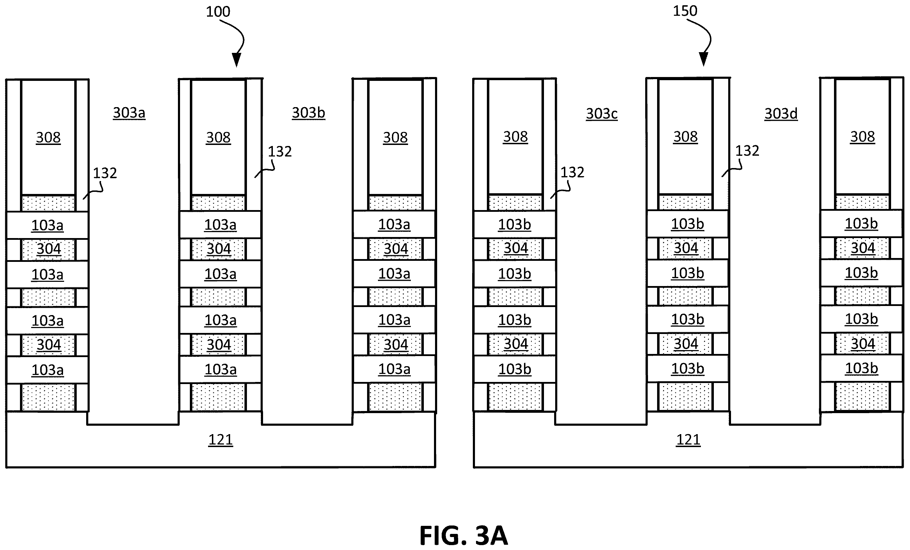

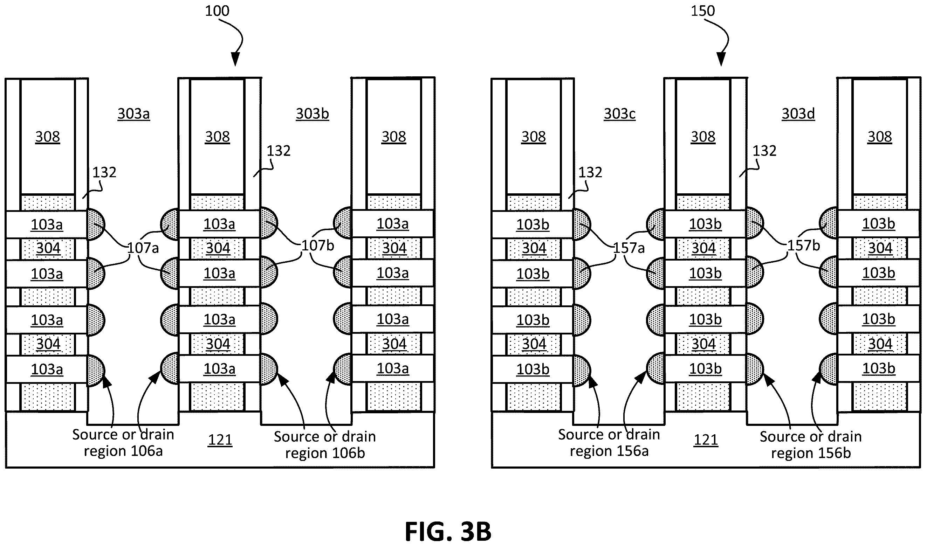

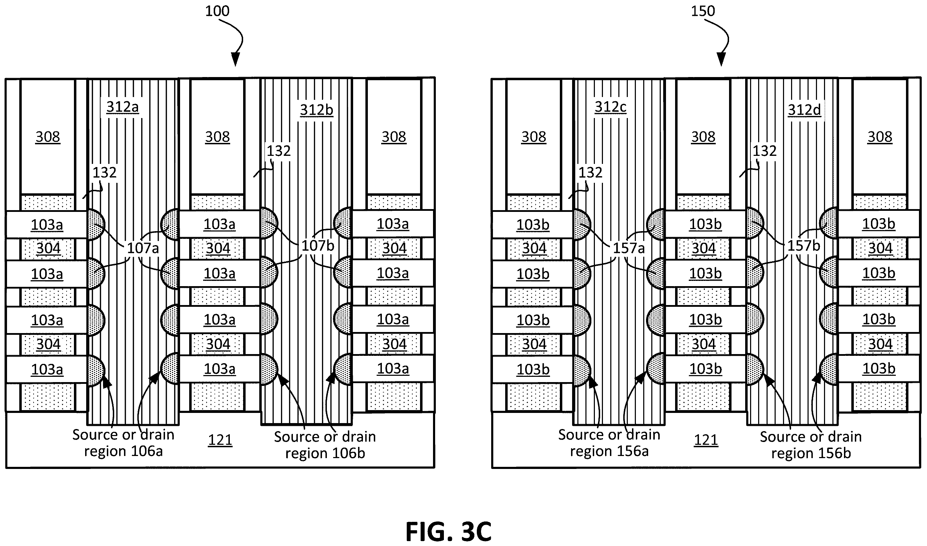

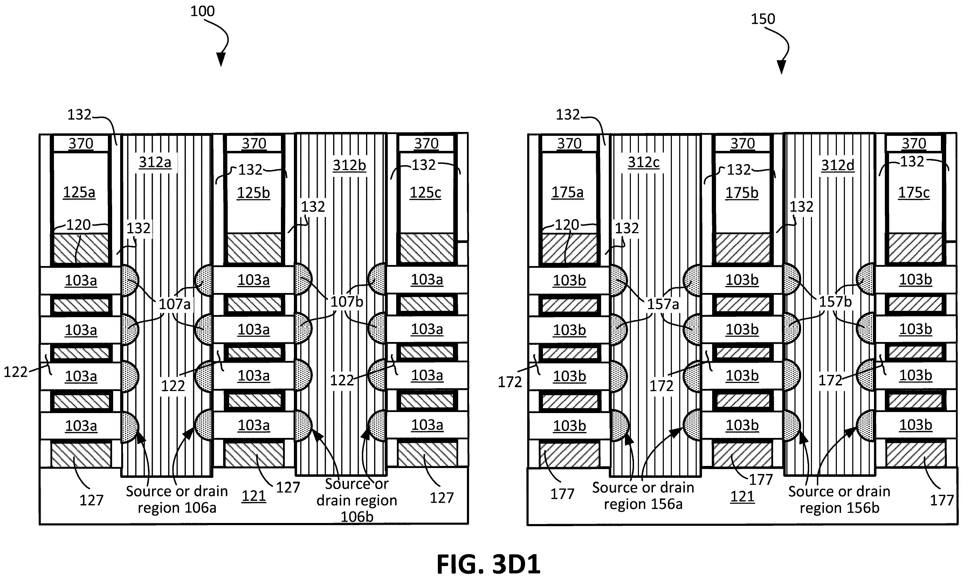

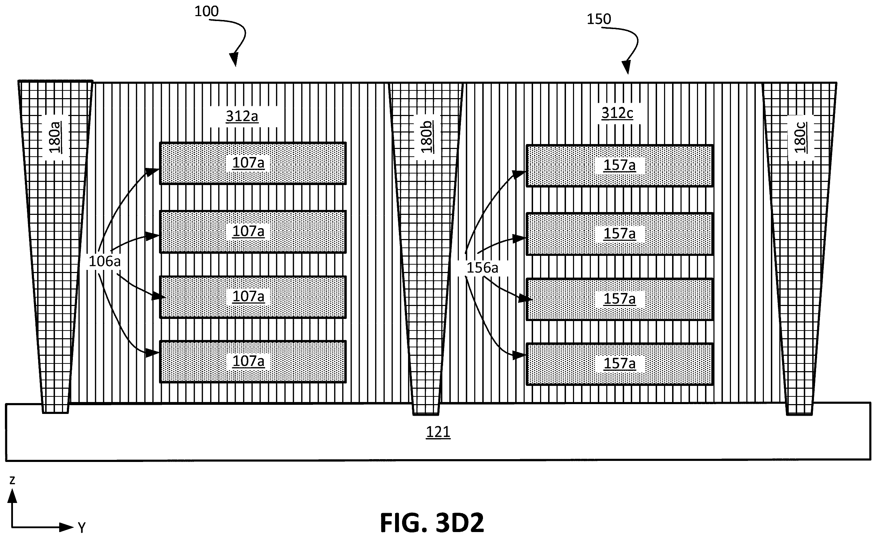

Figs. 2A, 2B, and 2C, in combination, illustrate a flowchart depicting a method 200 of forming the example first and second integrated circuit devices 100 and 150 of Figs. 1A-1D, in accordance with an embodiment of the present disclosure. Figs. 3A, 3B, 3C, 3D1, 3D2, 3E1, 3E2, 3F1, 3F2, 3G1, 3G2, 3H1, 3H2, 3I1, 3I2, 3J1, 3J2, 3K1, 3K2, 3L1, 3L2, 3M1, 3M2, 3N1, and 3N2 collectively illustrate cross-sectional views of an example integrated circuit structure in various stages of processing in accordance with the methodology of Figs. 2A, 2B, and 2C, in accordance with an embodiment of the present disclosure. Figs. 2A-2C and 3A-3K2 will be discussed in unison. The cross-sectional views of Figs. 3A, 3B, 3C, 3D1, 3E1, 3F1, 3G1, 3H1, 3I1, 3J1, 3K1, 3L1, 3M1, and 3N1 correspond to the cross-sectional views of Figs. 1A-1B and are gate-cut views centered on the channel regions. The cross-sectional views of Figs. 3D2, 3E2, 3F2, 3G2, 3H2, 3I2, 3J2, 3K2, 3L2, 3M2, and 3N2 correspond to the cross-sectional view of Fig. 1C and are channel-cut view centered in the source or drain regions.

Referring to Fig. 2A, the method 200 includes processes 204a, 208a, 212a for forming at least a portion of the device 100, and processes 204b, 208b, 212b for forming at least a portion of the device 150. In an example, the processes 2024, 208a, 212a may be performed at least in part simultaneously with, or sequentially with the processes 204b, 208b, 212b.

At process 204a, for the device 100, one or more fins comprising alternating layers of sacrificial material 304 and channel material 103a are formed, followed by formation of dummy gates 308 and source and drain trenches 303a, 303b, respectively, as illustrated in Fig. 3A. Similarly, at process 204b, for the device 150, one or more fins comprising alternating layers of sacrificial material 304 and channel material 103b are formed, followed by formation of dummy gates 308 and source and drain trenches 303c, 303d, respectively, as also illustrated in Fig. 3A. The processes 204a, 204b may be performed using appropriate techniques to form such components of GAA devices, in an example.

Method 200 proceeds from process 204a to process 208a. At 208a, for the device 100, portions 107a of the source region 106a are formed within the trench 303a, and portions 107b of the drain region 106b are formed within the trench 303b, as illustrated in Fig. 3B. For example, each of the portions 107a, 107b is epitaxially grown from a corresponding end of a corresponding nanoribbon 103a. The epitaxial growth process is timed, such that the epitaxial growth process is terminated before the various portions can grow enough to merge with each other. Thus, the various portions remain un-merged and discrete, as illustrated in Fig. 3B. Also, at 208a, remaining sections of the source or drain trenches 303a, 303b, which are not filled with the corresponding portions of the source or drain regions, are filled with dummy source or drain contact materials 312a, 312b, respectively, as illustrated in Fig. 3C. The dummy source or drain contact materials are sacrificial in nature, and will later be removed.

Similarly, method 200 also proceeds from process 204b to process 208b. At 208b, for the device 150, portions 157a of the source region 156a are formed within the trench 303c, and portions 157b of the drain region 156b are formed within the trench 303d, as also illustrated in Fig. 3B. For example, each of the portions 157a, 157b is epitaxially grown from a corresponding end of a corresponding nanoribbon 103b. The epitaxial growth process is timed, such that the epitaxial growth process is terminated before the various portions can grow enough to merge with each other. Thus, the various portions remain un-merged and discrete, as illustrated in Fig. 3B. Also, at 208b, remaining sections of the source or drain trenches 303c, 303d, which are not filled with the corresponding portions of the source or drain regions, are filled with dummy source or drain contact materials 312c, 312d, respectively, as illustrated in Fig. 3C. The dummy source or drain contact materials are sacrificial in nature, and will later be removed.

Also, note that as illustrated in below described Fig. 3D2, two adjacent source or drain trenches of two adjacent devices are separated by a wall or layer 180 of dielectric material, as also described above with respect to Fig. 1C. For example, the source or drain trench 303a of the device 100 and the source or drain trench 303c of the device 150 is separated by a wall or layer 180b of dielectric material. The walls or layers 180 may be formed at any appropriate point during the processes 204a, 204b, 208a, 208b, using techniques for forming such walls or layers.

Method 200 proceeds from process 208a to process 212a, and from process 208b to 212b. At 212a, for the device 100, the nanoribbons 103a are released by removing the dummy gate 308 to expose the channel region, and the sacrificial material 304 is selectively removed from the exposed nanoribbons 103a of the channel region, and the final gate stack 122 is formed, as illustrated in Figs. 3D1 and 3D2. Similarly, at 212b, for the device 150, the nanoribbons 103b are released by removing the dummy gate 308 to expose the channel region and the sacrificial material 304 is selectively removed from the exposed nanoribbons 103b of the channel region, and the final gate stack 172 is formed, as also illustrated in Figs. 3D1 and 3D2. The processes 212a, 212b may be performed using appropriate techniques to form such components of GAA devices, in an example. Note that the final gate stacks 122, 172 may be covered with a layer 370 of dielectric material, e.g., to protect the gate stacks 122, 172 during the source or drain contact formation processes, as illustrated in Fig. 3D1. Later in the process, the layer 370 above a gate stack may be selectively removed, to form a gate contact contacting the gate stack.

Method 200 proceeds from processes 212a and 212b to process 216. Note that processes 216-232 of the method 200 are for forming the source or drain contacts 178a, 178b of the device 150, and processes 236-248 of the method 200 are for forming the source or drain contacts 118a, 118b of the device 100. Thus, in this example the source or drain contacts 178a, 178b of the device 150 are formed prior to formation of the source or drain contacts 118a, 118b of the device 100. However, in another example, the process flow may be reversed, and the source or drain contacts 178a, 178b of the device 150 may be formed subsequent to formation of the source or drain contacts 118a, 118b of the device 100.

At 216 of the method 200, a lower mask 340 and an upper mask 342 are patterned above at least the dummy source or drain contact material 312a, 312b of the device 100, wherein the masks 340 and 342 don't cover at least portions of the dummy source or drain contact material 312c, 312d of the device 150, as illustrated in Figs. 3E1 and 3E2. In an example, one or both the masks 340 and 342 are hard masks, such as a carbon based hard mask and/or a silicon oxide (SiO2) based mask, and/or may comprises an appropriate nitride, oxide, carbide, oxycarbide, oxynitride, and/or oxycarbonitride. In an example, the masks 340 and 342 are etch selective with respect to each other.

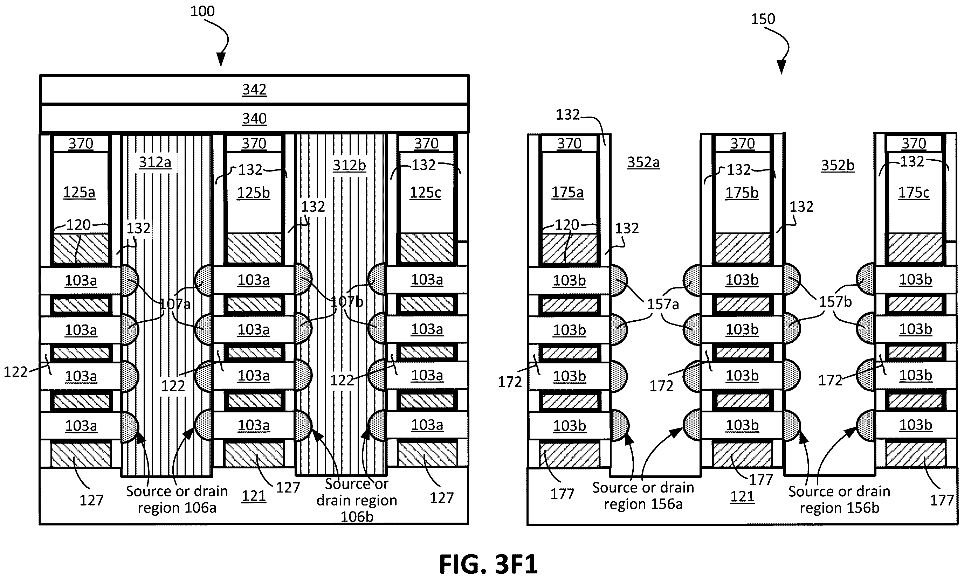

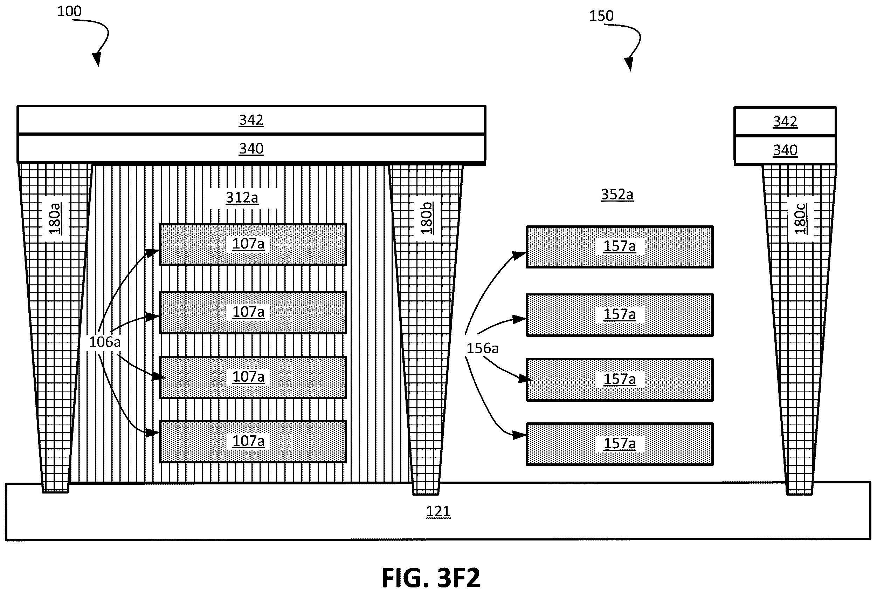

Method 200 proceeds from process 216 to process 220. At 220, the dummy source or drain contact materials 312c, 312d are removed from the device 150, to respectively form recesses 352a, 352b, as illustrated in Figs. 3F1 and 3F2. For example, as the dummy source or drain contact materials 312c, 312d were not covered by the masks 340, 342, the dummy source or drain contact materials 312c, 312d are removed through openings within the masks 340, 342, e.g., using an appropriate etch process. The device 100, including the dummy source or drain contact materials 312a, 312b are protected by the masks 340, 343, and are not substantially etched or removed.

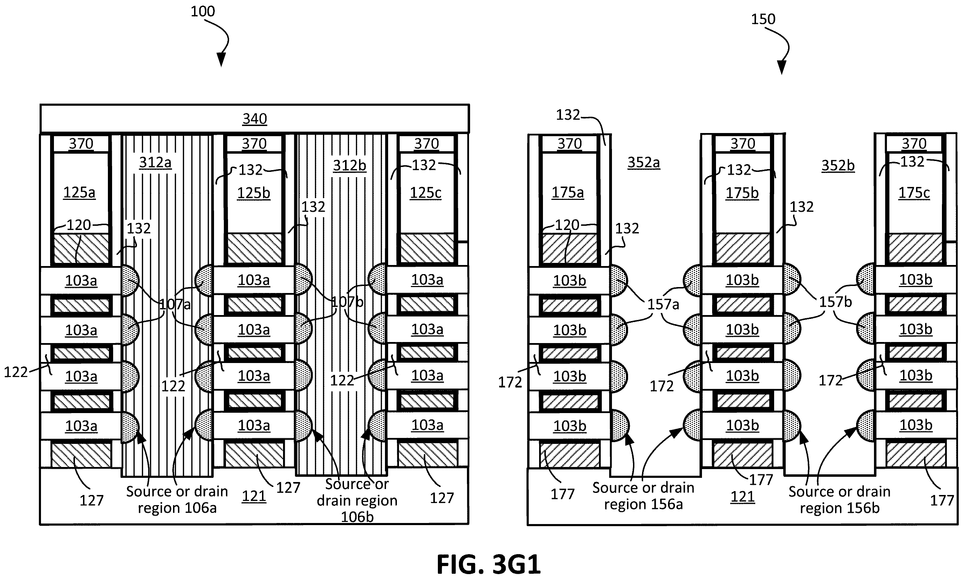

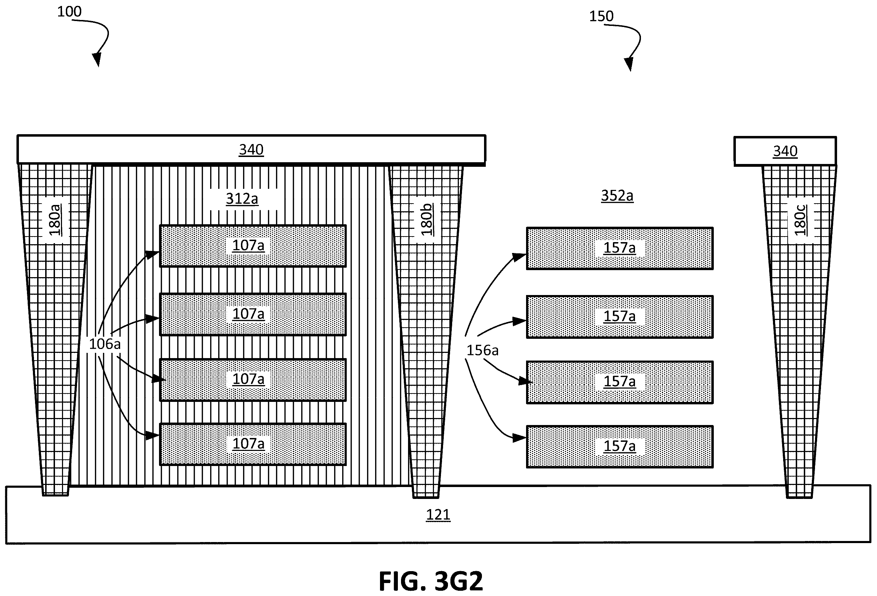

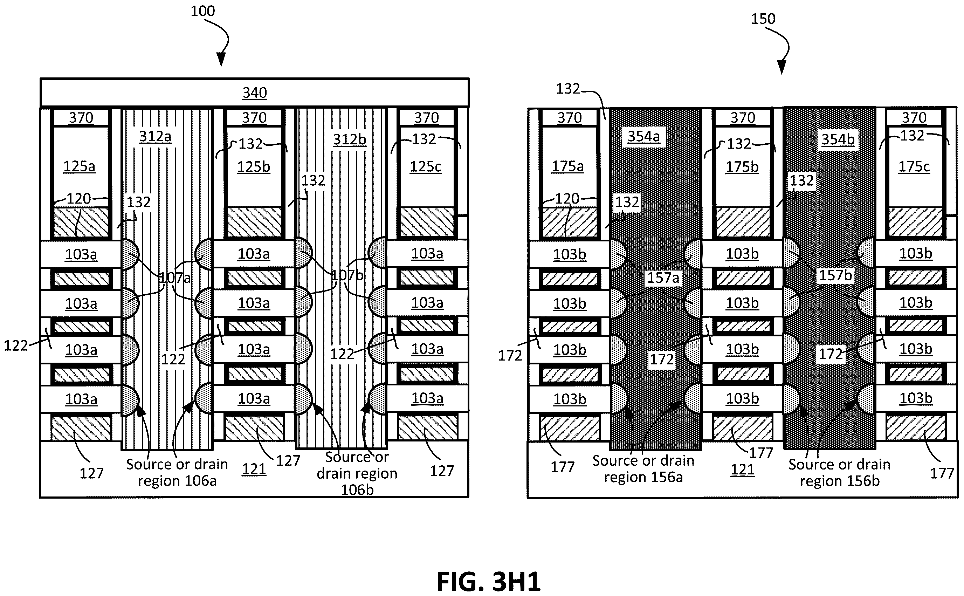

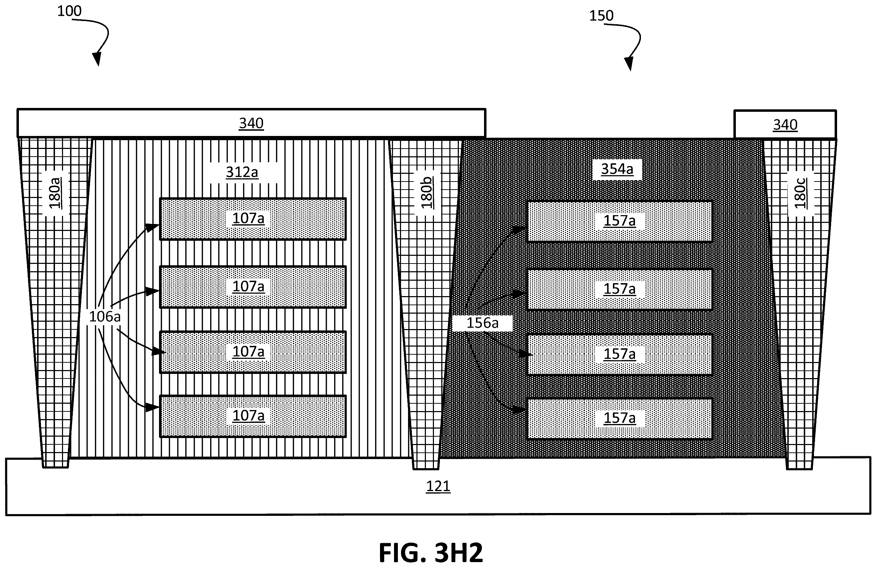

Method 200 proceeds from process 220 to process 224. Process 224 and subsequent processes of method 200 are illustrated in Fig. 2B. At 224, the upper mask 342 is removed, as illustrated in Figs. 3G1 and 3G2. Subsequently, also at 224, sacrificial material 354a and 354b are deposited within the recesses 352a, 352b, respectively, as illustrated in Figs. 3H1 and 3H2. The upper mask 342 is removed using a mask removal process, such as an etch process or an ashing process. The sacrificial materials 354a, 354b are deposited, to facilitate subsequent removal of the lower mask 340.

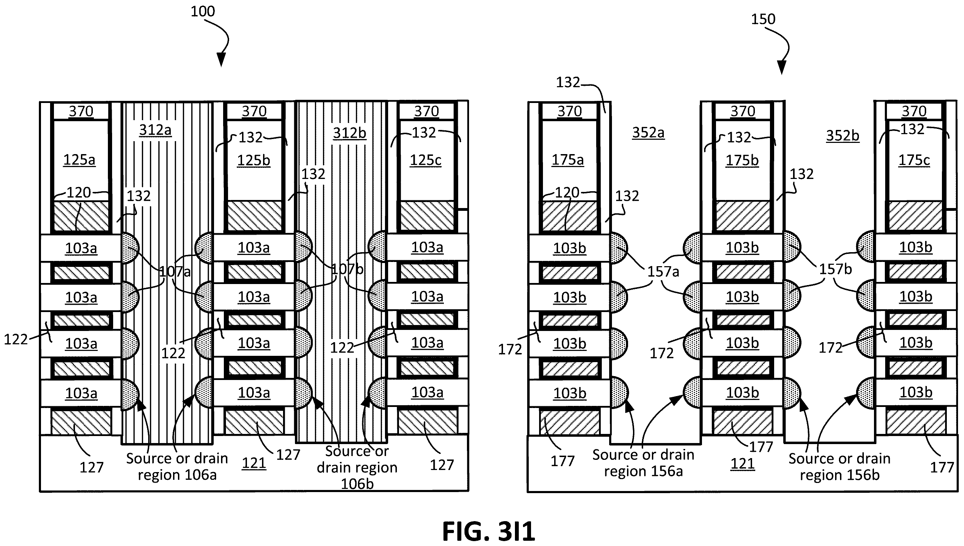

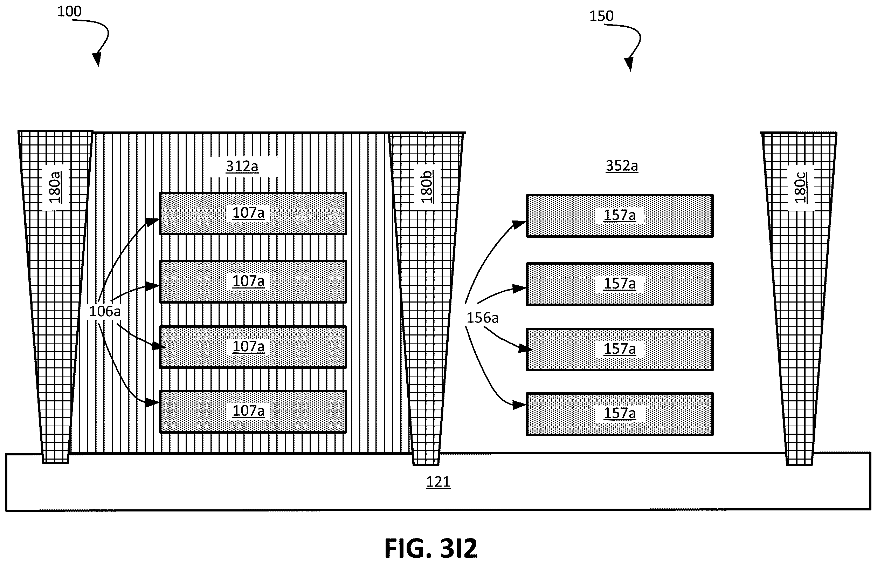

Method 200 proceeds from process 224 to process 228. At 228, the lower mask 340 is removed, as illustrated in Figs. 3I1 and 3I2. Also at 228, subsequent to removal of the lower mask 340, the sacrificial materials 354a and 354b are removed, to again from the recesses 352a, 352b, respectively, as also illustrated in Figs. 3I1 and 3I2. The lower mask 340 is removed using a mask removal process, such as an etch process or an ashing process. Subsequently, the sacrificial materials 354a and 354b are removed using an etching or ashing process.

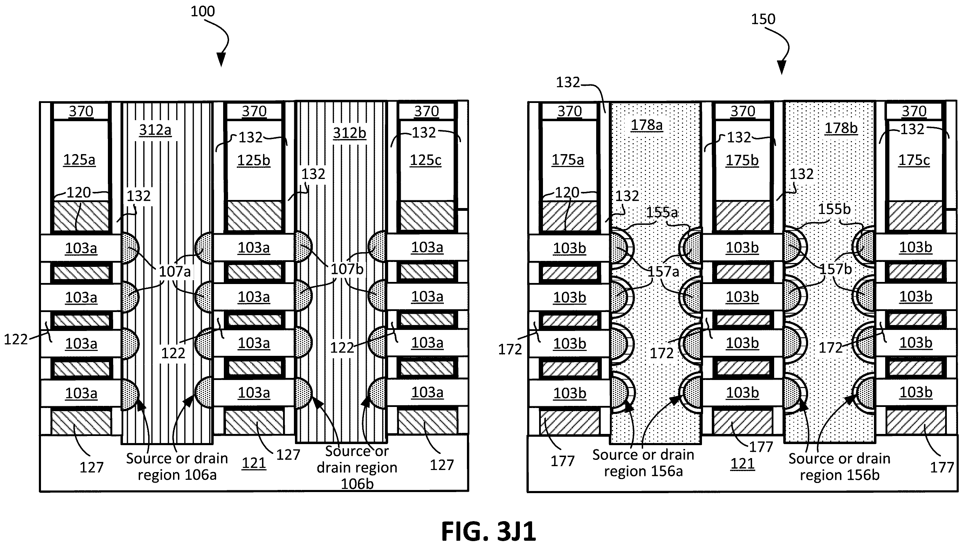

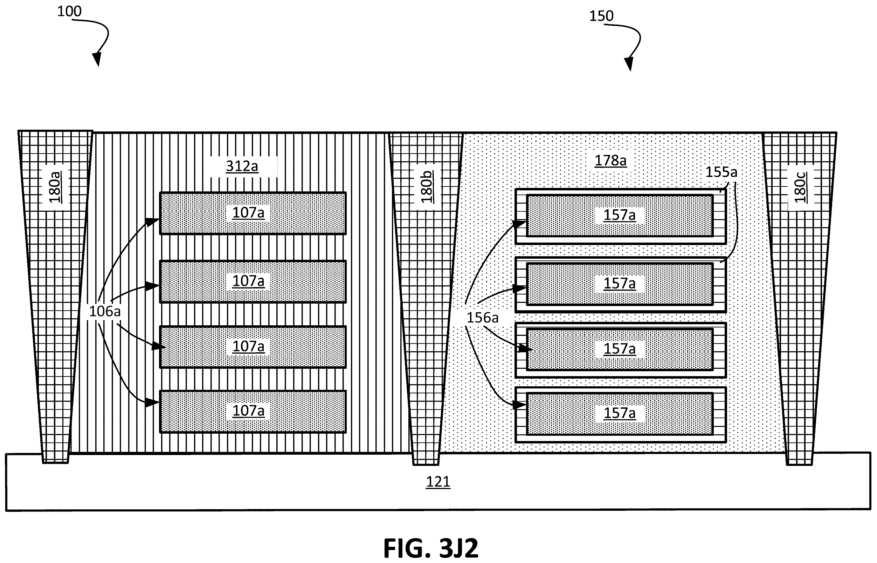

Method 200 proceeds from process 228 to process 232. At 232, conductive materials are deposited within the recesses 352a, 352b, to respectively form the source or drain contacts 178a, 178b for the source or drain regions 156a, 156b, respectively of the device 150, as illustrated in Figs. 3J1 and 3J2. In an example, prior to or during deposition of the conductive materials, the conductive lining layers 155a, 155b (e.g., comprising silicide layer(s), germanide layer(s), germanosilicide layer(s), and/or adhesive layer(s)) may also be formed. Example conductive materials for the source or drain contacts 178a, 178b are described above. In an example, the conductive materials are deposited using an appropriate deposition technique, such as chemical vapor deposition (CVD), physical vapor deposition (PVD), atomic layer deposition (ALD), vapor-phase epitaxy (VPE), molecular beam epitaxy (MBE), or liquid-phase epitaxy (LPE), for example. As also described above, the deposition chemistry may be controlled (such as controlling process parameters, e.g., reactants used in the deposition technique, temperature, pressure, and/or co-reactants), to tune an amount of strain induced by the source or drain contacts 178a, 178b on the corresponding nanoribbons 103b. In an example, the deposited conductive materials may be planarized using an appropriate planarization technique, such as mechanical polishing or chemical-mechanical polishing (CMP). This completes formation of the source and drain contacts 178a, 178b of the device 150.

Method 200 proceeds from process 232 to process 236. Processes 236-248 are associated with formation of the source and drain contacts 118a, 118b of the device 100, and may be at least in part similar to the above described processes 216-232 for formation of the source and drain contacts 178a, 178b of the device 150.

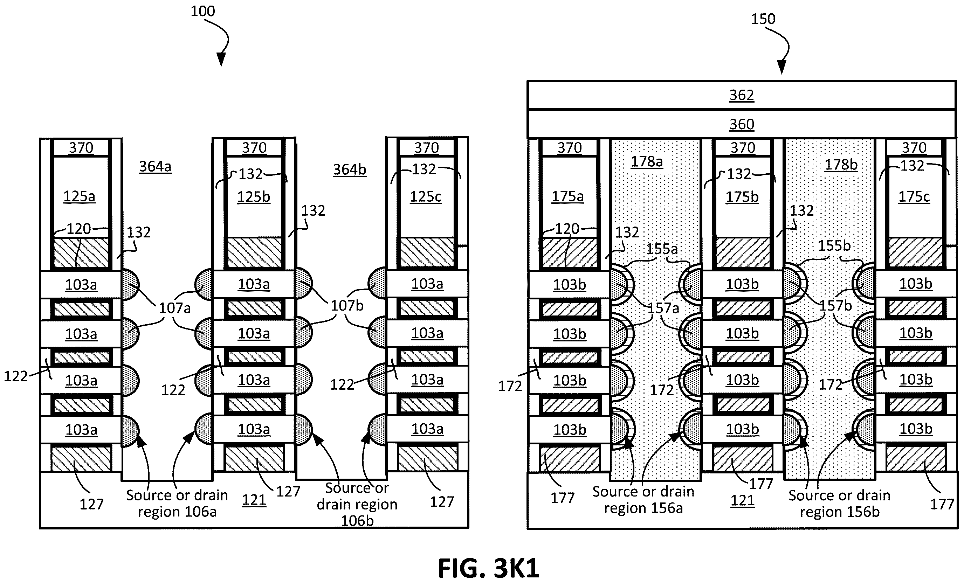

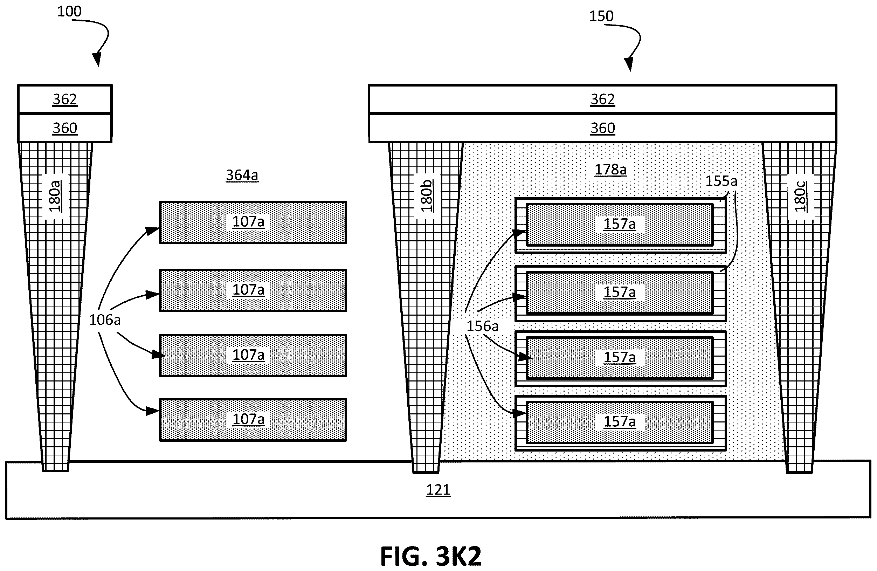

At 236, a lower mask 360 and an upper mask 362 are patterned above at least the source or drain contacts 178a, 178b of the device 150, wherein the masks 360 and 362 don't cover at least portions of the dummy source or drain contact material 312a, 312a of the device 100; and subsequently the dummy source or drain contact materials 312a, 312b are removed from the device 100, to respectively form recesses 364a, 364b, as illustrated in Figs. 3K1 and 3K2. Thus, process 236 is at least in part similar to the processes 216 and 220 described above.

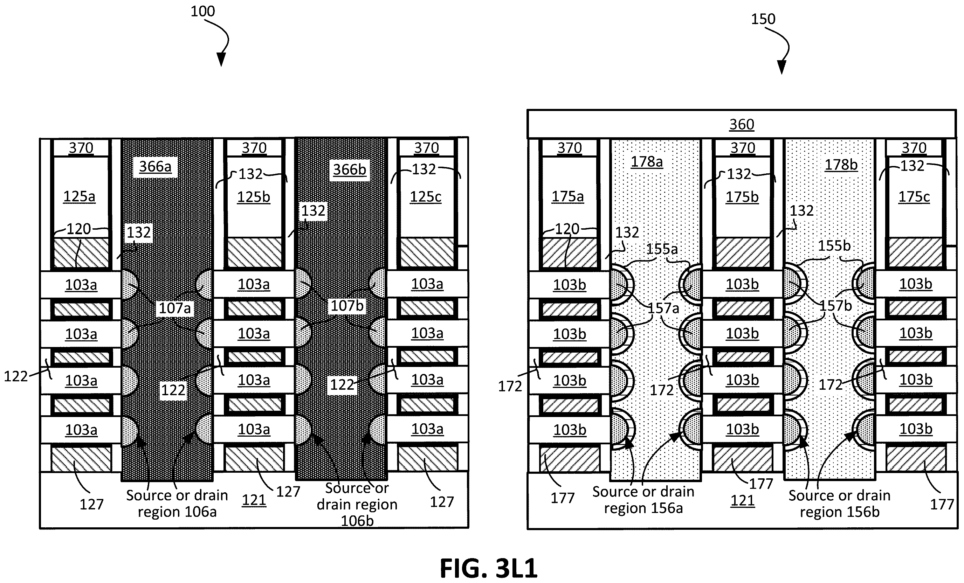

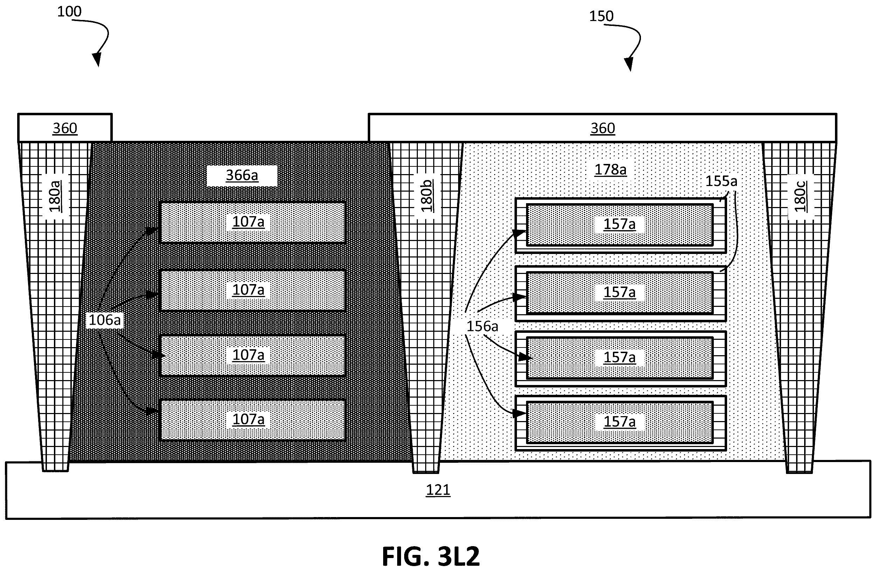

Method 200 proceeds from process 236 to process 240. At 240, the upper mask 362 is removed, and subsequently sacrificial materials 366a and 366b are deposited within the recesses 364a, 364b, respectively of the device 100, as illustrated in Figs. 3L1 and 3L2. Thus process 240 is at least in part similar to the process 224 described above.

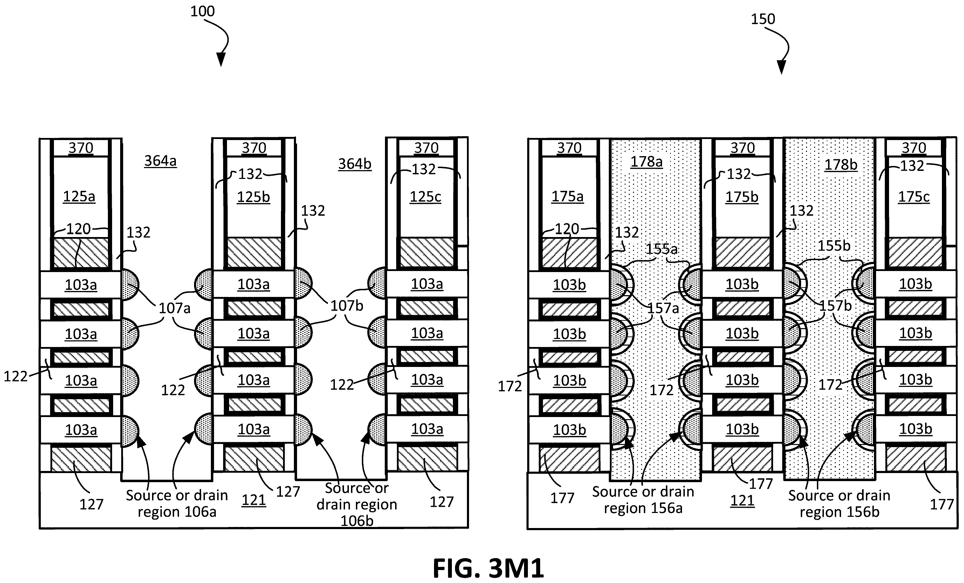

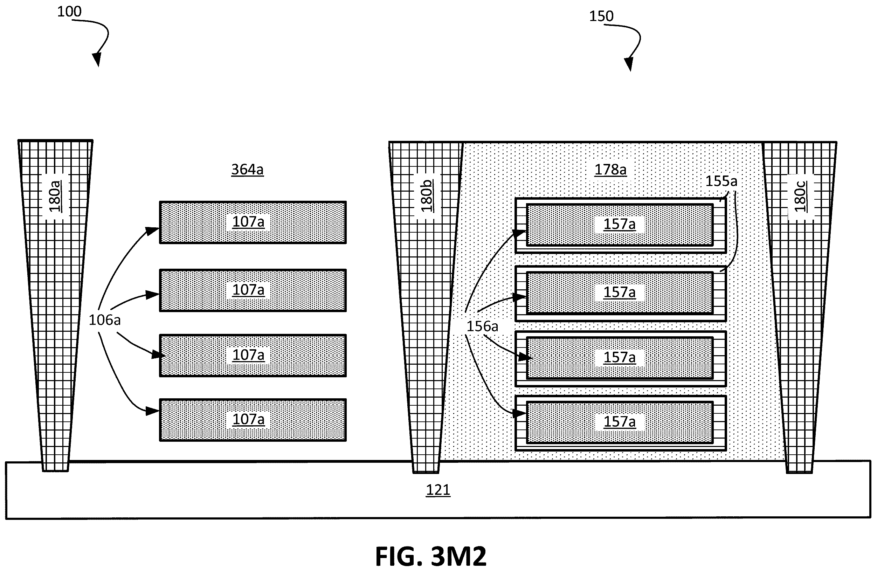

Method 200 proceeds from process 240 to process 244 illustrated in Fig. 2C. At 244, the lower mask 360 is removed, and subsequently the sacrificial materials 366a and 366b are removed, to again form the recesses 364a, 364b, respectively, as illustrated in Figs. 3M1 and 3M2. Thus process 244 is at least in part similar to the process 228 described above.

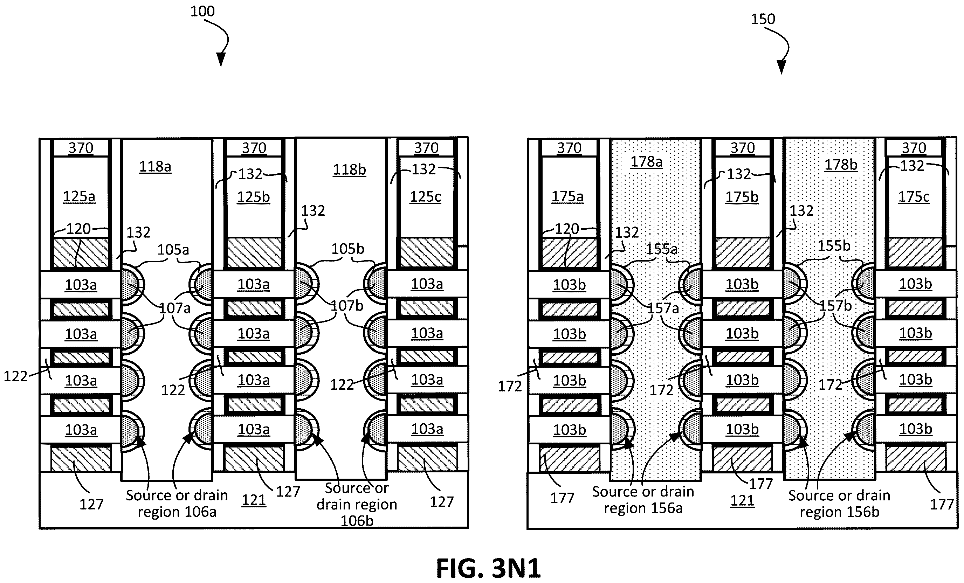

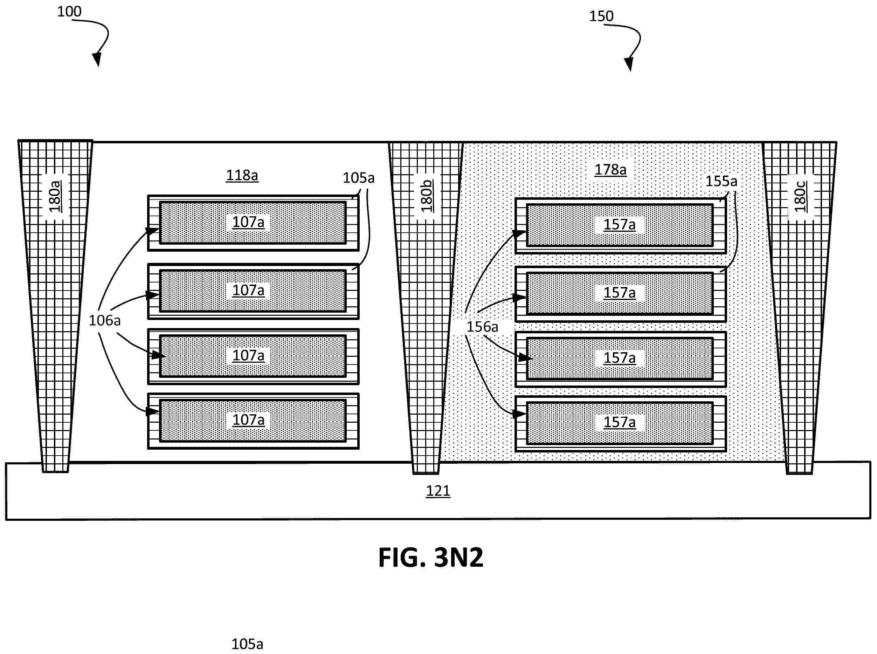

Method 200 proceeds from process 244 to process 248. At 248, conductive materials are deposited within the recesses 364a, 364b, to respectively form the source or drain contacts 118a, 118b for the source or drain regions 106a, 106b, respectively, of the device 100, as illustrated in Figs. 3N1 and 3N2. In an example, prior to or during deposition of the conductive materials, the conductive lining layers 105a, 105b (e.g., comprising silicide layer(s), germanide layer(s), germanosilicide layer(s), and/or adhesive layer(s)) may also be formed. The process 244 is at least in part similar to the process 228 described above. Example conductive materials for the source or drain contacts 118a, 118b are described above. In an example, the conductive materials are deposited using appropriate deposition techniques, such as CVD, PVD, ALD, VPE, MBE, or LPE, for example. As also described above, the deposition chemistry may be controlled, to tune an amount of strain induced by the source or drain contacts 118a, 118b on the corresponding nanoribbons 103a. In an example, the deposited conductive materials may be planarized using an appropriate planarization technique, such as mechanical polishing or CMP. This completes formation of the source and drain contacts 118a, 118b of the device 100.

Method 200 proceeds from process 248 to process 252. At 252, a general integrated circuit (IC) is completed, as desired, in accordance with some embodiments. Such additional processing to complete an IC may include forming one or more gate contacts (e.g., after removal of the dielectric material layer 370 illustrated in Fig. 3N1), back-end or back-end-of-line (BEOL) processing to form one or more metallization layers, and/or to interconnect the transistor devices formed, for example. Any other suitable processing may be performed, as will be apparent in light of this disclosure.

Note that the processes in method 200 are shown in a particular order for ease of description. However, one or more of the processes may be performed in a different order or may not be performed at all (and thus be optional), in accordance with some embodiments. For example, processes 216-232 of the method 200 are for forming the source or drain contacts 178a, 178b of the device 150, and processes 236-248 of the method 200 are for forming the source or drain contacts 118a, 118b of the device 100. Thus, in this example the source or drain contacts 178a, 178b of the device 150 are formed prior to formation of the source or drain contacts 118a, 118b of the device 100. However, in another example, the process flow may be reversed, and the source or drain contacts 178a, 178b of the device 150 may be formed subsequent to formation of the source or drain contacts 118a, 118b of the device 100. Numerous variations on method 200 and the techniques described herein will be apparent in light of this disclosure.

### Example System

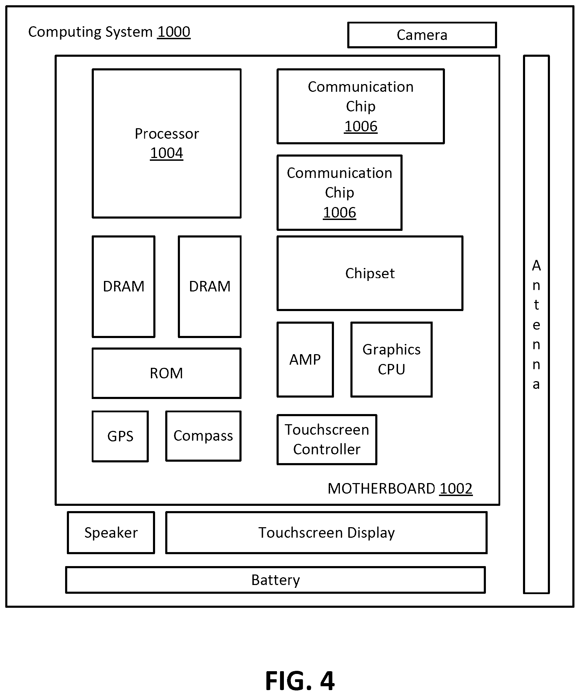

Fig. 4 illustrates a computing system 1000 implemented with integrated circuit structures formed using the techniques disclosed herein, in accordance with some embodiments of the present disclosure. As can be seen, the computing system 1000 houses a motherboard 1002. The motherboard 1002 may include a number of components, including, but not limited to, a processor 1004 and at least one communication chip 1006, each of which can be physically and electrically coupled to the motherboard 1002, or otherwise integrated therein. As will be appreciated, the motherboard 1002 may be, for example, any printed circuit board, whether a main board, a daughterboard mounted on a main board, or the only board of system 1000, etc.

Depending on its applications, computing system 1000 may include one or more other components that may or may not be physically and electrically coupled to the motherboard 1002. These other components may include, but are not limited to, volatile memory (e.g., DRAM), non-volatile memory (e.g., ROM), a graphics processor, a digital signal processor, a crypto processor, a chipset, an antenna, a display, a touchscreen display, a touchscreen controller, a battery, an audio codec, a video codec, a power amplifier, a global positioning system (GPS) device, a compass, an accelerometer, a gyroscope, a speaker, a camera, and a mass storage device (such as hard disk drive, compact disk (CD), digital versatile disk (DVD), and so forth). Any of the components included in computing system 1000 may include one or more integrated circuit structures or devices formed using the disclosed techniques in accordance with an example embodiment. In some embodiments, multiple functions can be integrated into one or more chips (e.g., for instance, note that the communication chip 1006 can be part of or otherwise integrated into the processor 1004).

The communication chip 1006 enables wireless communications for the transfer of data to and from the computing system 1000. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. The communication chip 1006 may implement any of a number of wireless standards or protocols, including, but not limited to, Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 3G, 4G, 5G, and beyond. The computing system 1000 may include a plurality of communication chips 1006. For instance, a first communication chip 1006 may be dedicated to shorter range wireless communications such as Wi-Fi and Bluetooth and a second communication chip 1006 may be dedicated to longer range wireless communications such as GPS, EDGE, GPRS, CDMA, WiMAX, LTE, Ev-DO, and others.

The processor 1004 of the computing system 1000 includes an integrated circuit die packaged within the processor 1004. In some embodiments, the integrated circuit die of the processor includes onboard circuitry that is implemented with one or more integrated circuit structures or devices formed using the disclosed techniques, as variously described herein. The term "processor" may refer to any device or portion of a device that processes, for instance, electronic data from registers and/or memory to transform that electronic data into other electronic data that may be stored in registers and/or memory.

The communication chip 1006 also may include an integrated circuit die packaged within the communication chip 1006. In accordance with some such example embodiments, the integrated circuit die of the communication chip includes one or more integrated circuit structures or devices formed using the disclosed techniques as variously described herein. As will be appreciated in light of this disclosure, note that multistandard wireless capability may be integrated directly into the processor 1004 (e.g., where functionality of any chips 1006 is integrated into processor 1004, rather than having separate communication chips). Further note that processor 1004 may be a chip set having such wireless capability. In short, any number of processor 1004 and/or communication chips 1006 can be used. Likewise, any one chip or chip set can have multiple functions integrated therein.

In various implementations, the computing system 1000 may be a laptop, a netbook, a notebook, a smartphone, a tablet, a personal digital assistant (PDA), an ultra-mobile PC, a mobile phone, a desktop computer, a server, a printer, a scanner, a monitor, a set-top box, an entertainment control unit, a digital camera, a portable music player, a digital video recorder, or any other electronic device or system that processes data or employs one or more integrated circuit structures or devices formed using the disclosed techniques, as variously described herein. Note that reference to a computing system is intended to include computing devices, apparatuses, and other structures configured for computing or processing information.

### Further Example Embodiments

The following examples pertain to further embodiments, from which numerous permutations and configurations will be apparent.

Example 1. An integrated circuit structure, comprising: a first device comprising (i) a first source or drain region having a first plurality of portions that are discontinuous from each other, (ii) a first plurality of bodies comprising semiconductor material, each body of the first plurality of bodies laterally extending from a corresponding one of the first plurality of portions, and (iii) a first source or drain contact comprising a first conductive material and coupled to the first plurality of portions; and a second device comprising (i) a second source or drain region having a second plurality of portions that are discontinuous from each other, (ii) a second plurality of bodies comprising semiconductor material, each body of the second plurality of bodies laterally extending from a corresponding one of the second plurality of portions, and (iii) a second source or drain contact comprising a second conductive material and coupled to the second plurality of portions; wherein the first conductive material is elementally different from the second conductive material.

Example 2. The integrated circuit structure of example 1, wherein: the first device is a p-channel device, and the first conductive material of the first source or drain contact induces compressive strain on one or more bodies of the first plurality of bodies of the first device; and the second device is an n-channel device, and the second conductive material of the second source or drain contact induces tensile strain on one or more bodies of the second plurality of bodies of the second device.

Example 3. The integrated circuit structure of any one of examples 1-2, wherein: the first conductive material of the first source or drain contact comprises molybdenum and induces compressive strain on one or more bodies of the first plurality of bodies of the first device; and the second conductive material of the second source or drain contact comprises at least one of tungsten, titanium, vanadium, cobalt, and nitrogen, and induces tensile strain on one or more bodies of the second plurality of bodies of the second device.

Example 4. The integrated circuit structure of any one of examples 1-3, wherein the first conductive material comprises a first metal, and wherein the second conductive material comprises a second metal and not the first metal, and wherein the first conductive material does not comprise the second metal.

Example 5. The integrated circuit structure of any one of examples 1-4, wherein: the first device further comprises (i) a third source or drain region having a third plurality of portions that are discontinuous from each other, and (ii) a third source or drain contact comprising the first conductive material and coupled to the third plurality of portions; and each body of the first plurality of bodies laterally extends between the corresponding one of the first plurality of portions and a corresponding one of the third plurality of portions.

Example 6. The integrated circuit structure of any one of examples 1-5, wherein: the second device further comprises (i) a third source or drain region having a third plurality of portions that are discontinuous from each other, and (ii) a third source or drain contact comprising the second conductive material and coupled to the third plurality of portions; and each body of the second plurality of bodies laterally extends between the corresponding one of the second plurality of portions and a corresponding one of the third plurality of portions.

Example 7. The integrated circuit structure of any one of examples 1-6, wherein: a first portion of the first plurality of portions and a second portion of the first plurality of portions are separated by the first source or drain contact.

Example 8. The integrated circuit structure of any one of examples 1-7, further comprising: a wall comprising dielectric material laterally between and separating the first source or drain contact of the first device and the second source or drain contact of the second device, wherein each of the first source or drain contact and the second source or drain contact is at most at a distance of 5 nanometers from the wall.

Example 9. The integrated circuit structure of any one of examples 1-8, wherein the first device comprises a first gate structure at least partially wrapped around each of first plurality of bodies, and wherein the second device comprises a second gate structure at least partially wrapped around each of second plurality of bodies.

Example 10. The integrated circuit structure of any one of examples 1-9, wherein each of the first plurality of bodies and the second plurality of bodies comprises a nanoribbon, a nanowire, or a nanosheet.

Example 11. A method comprising: forming a first source or drain trench of a first device, and a second source or drain trench of a second device; forming a first source or drain region within a first section of the first source or drain trench, the first source or drain region comprising a first plurality of portions that are disconnected from each other; forming a second source or drain region within a first section of the second source or drain trench, the second source or drain region comprising a second plurality of portions that are disconnected from each other; forming a first source or drain contact within a second section of the first source or drain trench, the first source or drain contact coupled to each of the first plurality of portions and comprising a first conductive material; and forming a second source or drain contact within a second section of the second source or drain trench, the second source or drain contact coupled to each of the second plurality of portions and comprising a second conductive material; wherein the first conductive material is elementally different from the second conductive material.

Example 12. The method of example 11, wherein forming the second source or drain contact comprises: subsequent to forming the first source or drain region within the first source or drain trench and the second source or drain region within the second source or drain trench, filling the second sections of the first source or drain trench and the second source or drain trench with a first sacrificial material and a second sacrificial material, respectively; subsequent to filling with the first sacrificial material and the second sacrificial material, masking the first sacrificial material with a lower mask above the first sacrificial material, and an upper mask above the lower mask; subsequent to masking with the lower mask and the upper mask, removing the second sacrificial material from the second source or drain trench; subsequent to removing the second sacrificial material, removing the upper mask; and subsequent to removing the upper mask, refilling the second section of the second source or drain trench with a third sacrificial material.

Example 13. The method of example 12, wherein forming the second source or drain contact further comprises: subsequent to refilling with the third sacrificial material, removing the lower mask; subsequent to removing the lower mask, removing the third sacrificial material from the second source or drain trench; and subsequent to removing the third sacrificial material, filling the second section of the second source or drain trench with the second conductive material, thereby forming the second source or drain contact within the second source or drain trench.

Example 14. The method of any one of examples 11-13, wherein forming the first source or drain contact comprises: subsequent to forming the first source or drain region within the first source or drain trench and the second source or drain region within the second source or drain trench, filling the second sections of the first source or drain trench and the second source or drain trench with a first sacrificial material and a second sacrificial material, respectively; and subsequent to filling with the first sacrificial material and the second sacrificial material, (i) masking the first sacrificial material with one or more masks, (ii) removing the second sacrificial material, and (iii) filling the second section of the second source or drain trench with the second conductive material, thereby forming the second source or drain contact within the second source or drain trench.

Example 15. The method of any one of examples 11-14, wherein prior to forming the first source or drain region, end sections of a plurality of bodies of semiconductor material are exposed through the first source or drain trench, and wherein forming the first source or drain region comprises: epitaxially growing, within the first source or drain trench, a first portion of the first plurality of portions of the first source or drain region from an end section of a first body of the plurality of bodies of semiconductor material; epitaxially growing, within the first source or drain trench, a second portion of the first plurality of portions of the first source or drain region from an end section of a second body of the plurality of bodies of semiconductor material; and terminating the epitaxial growth of the first portion and the second portion, prior to merging of the first and second portion, thereby resulting in the first portion of the plurality of portions of the first source or drain region being discontinuous from the second portion of the plurality of portions of the first source or drain region.

Example 16. The method of any one of examples 11-15, wherein: the first device is a p-channel metal-oxide semiconductor (PMOS) device, and the first conductive material of the first source or drain region induces compressive strain on each of a first plurality of bodies of semiconductor material extending laterally from the first plurality of portions of the first source or drain region; and the second device is a n-channel metal-oxide semiconductor (NMOS) device, and the second conductive material of the second source or drain region induces tensile strain on each of a second plurality of bodies of semiconductor material extending laterally from the second plurality of portions of the second source or drain region.

Example 17. An integrated circuit structure, comprising: a device comprising a first source or drain region having a first plurality of individual nubs spaced from each other; a second source or drain region having a second plurality of individual nubs spaced from each other; a plurality of bodies comprising semiconductor material, each body of the plurality of bodies laterally extending between a corresponding one of the first plurality of nubs and a corresponding one of the second plurality of nubs; a first source or drain contact comprising a conductive material and coupled to each of the first plurality of nubs; and a second source or drain contact comprising the conductive material and coupled to each of the second plurality of nubs; wherein the conductive material of the first and second source or drain contacts induces a uniaxial strain within one or more of the plurality of bodies.

Example 18. The integrated circuit structure of example 17, wherein one of: the device is a p-channel device, and the uniaxial strain induced within one or more of the plurality of bodies by the conductive material of the first and second source or drain contacts is a uniaxial compressive strain; or the device is an n-channel device, and the uniaxial strain induced within one or more of the plurality of bodies by the conductive material of the first and second source or drain contacts is a uniaxial tensile strain.

Example 19. The integrated circuit structure of any one of examples 17-18, wherein the device is a first device, the plurality of bodies is a first plurality of bodies, and the conductive material is a first conductive material, and wherein the integrated circuit structure comprises: a second device comprising a third source or drain region having a third plurality of individual nubs spaced from each other; a fourth source or drain region having a fourth plurality of individual nubs spaced from each other; a second plurality of bodies comprising semiconductor material, each body of the second plurality of bodies laterally extending between a corresponding one of the third plurality of nubs and a corresponding one of the fourth plurality of nubs; a third source or drain contact comprising a second conductive material and coupled to each of the third plurality of nubs; and a fourth source or drain contact comprising the second conductive material and coupled to each of the fourth plurality of nubs; wherein the second conductive material is elementally different from the first conductive material.

Example 20. The integrated circuit structure of example 19, wherein: the first device is a p-channel device, and the uniaxial strain induced within one or more of the plurality of bodies by the first conductive material of the first and second source or drain contacts is a uniaxial compressive strain; and the second device is a n-channel device, and the second conductive material of the third and fourth source or drain contacts induces a uniaxial tensile strain within one or more of the second plurality of bodies.

The foregoing description of example embodiments of the present disclosure has been presented for the purposes of illustration and description. It is not intended to be exhaustive or to limit the present disclosure to the precise forms disclosed. Many modifications and variations are possible in light of this disclosure. It is intended that the scope of the present disclosure be limited not by this detailed description, but rather by the claims appended hereto.

## Claims

1. An integrated circuit structure, comprising:
a first device comprising (i) a first source or drain region having a first plurality of portions that are discontinuous from each other, (ii) a first plurality of bodies comprising semiconductor material, each body of the first plurality of bodies laterally extending from a corresponding one of the first plurality of portions, and (iii) a first source or drain contact comprising a first conductive material and coupled to the first plurality of portions; and
a second device comprising (i) a second source or drain region having a second plurality of portions that are discontinuous from each other, (ii) a second plurality of bodies comprising semiconductor material, each body of the second plurality of bodies laterally extending from a corresponding one of the second plurality of portions, and (iii) a second source or drain contact comprising a second conductive material and coupled to the second plurality of portions;
wherein the first conductive material is elementally different from the second conductive material.

2. The integrated circuit structure of claim 1, wherein:
the first device is a p-channel device, and the first conductive material of the first source or drain contact induces compressive strain on one or more bodies of the first plurality of bodies of the first device; and
the second device is an n-channel device, and the second conductive material of the second source or drain contact induces tensile strain on one or more bodies of the second plurality of bodies of the second device.

3. The integrated circuit structure of claim 1 or 2, wherein:
the first conductive material of the first source or drain contact comprises molybdenum and induces compressive strain on one or more bodies of the first plurality of bodies of the first device; and
the second conductive material of the second source or drain contact comprises at least one of tungsten, titanium, vanadium, cobalt, and nitrogen, and induces tensile strain on one or more bodies of the second plurality of bodies of the second device.

4. The integrated circuit structure of any one of claims 1 through 3, wherein the first conductive material comprises a first metal, and wherein the second conductive material comprises a second metal and not the first metal, and wherein the first conductive material does not comprise the second metal.

5. The integrated circuit structure of any one of claims 1 through 4, wherein:
the first device further comprises (i) a third source or drain region having a third plurality of portions that are discontinuous from each other, and (ii) a third source or drain contact comprising the first conductive material and coupled to the third plurality of portions; and
each body of the first plurality of bodies laterally extends between the corresponding one of the first plurality of portions and a corresponding one of the third plurality of portions.

6. The integrated circuit structure of any one of claims 1 through 5, wherein:
the second device further comprises (i) a third source or drain region having a third plurality of portions that are discontinuous from each other, and (ii) a third source or drain contact comprising the second conductive material and coupled to the third plurality of portions; and
each body of the second plurality of bodies laterally extends between the corresponding one of the second plurality of portions and a corresponding one of the third plurality of portions.

7. The integrated circuit structure of any one of claims 1 through 6, wherein:
a first portion of the first plurality of portions and a second portion of the first plurality of portions are separated by the first source or drain contact.

8. The integrated circuit structure of any one of claims 1 through 7, further comprising:
a wall comprising dielectric material laterally between and separating the first source or drain contact of the first device and the second source or drain contact of the second device, wherein each of the first source or drain contact and the second source or drain contact is at most at a distance of 5 nanometers from the wall.

9. The integrated circuit structure of any one of claims 1 through 8, wherein the first device comprises a first gate structure at least partially wrapped around each of first plurality of bodies, and wherein the second device comprises a second gate structure at least partially wrapped around each of second plurality of bodies.

10. The integrated circuit structure of any one of claims 1 through 9, wherein each of the first plurality of bodies and the second plurality of bodies comprises a nanoribbon, a nanowire, or a nanosheet.

11. A method comprising:
forming a first source or drain trench of a first device, and a second source or drain trench of a second device;
forming a first source or drain region within a first section of the first source or drain trench, the first source or drain region comprising a first plurality of portions that are disconnected from each other;
forming a second source or drain region within a first section of the second source or drain trench, the second source or drain region comprising a second plurality of portions that are disconnected from each other;
forming a first source or drain contact within a second section of the first source or drain trench, the first source or drain contact coupled to each of the first plurality of portions and comprising a first conductive material; and
forming a second source or drain contact within a second section of the second source or drain trench, the second source or drain contact coupled to each of the second plurality of portions and comprising a second conductive material;
wherein the first conductive material is elementally different from the second conductive material.

12. The method of claim 11, wherein forming the second source or drain contact comprises:
subsequent to forming the first source or drain region within the first source or drain trench and the second source or drain region within the second source or drain trench, filling the second sections of the first source or drain trench and the second source or drain trench with a first sacrificial material and a second sacrificial material, respectively;
subsequent to filling with the first sacrificial material and the second sacrificial material, masking the first sacrificial material with a lower mask above the first sacrificial material, and an upper mask above the lower mask;
subsequent to masking with the lower mask and the upper mask, removing the second sacrificial material from the second source or drain trench;
subsequent to removing the second sacrificial material, removing the upper mask; and
subsequent to removing the upper mask, refilling the second section of the second source or drain trench with a third sacrificial material.

13. The method of claim 12, wherein forming the second source or drain contact further comprises:
subsequent to refilling with the third sacrificial material, removing the lower mask;
subsequent to removing the lower mask, removing the third sacrificial material from the second source or drain trench; and
subsequent to removing the third sacrificial material, filling the second section of the second source or drain trench with the second conductive material, thereby forming the second source or drain contact within the second source or drain trench.

14. The method of any one of claims 11 through 13, wherein forming the first source or drain contact comprises:
subsequent to forming the first source or drain region within the first source or drain trench and the second source or drain region within the second source or drain trench, filling the second sections of the first source or drain trench and the second source or drain trench with a first sacrificial material and a second sacrificial material, respectively; and
subsequent to filling with the first sacrificial material and the second sacrificial material, (i) masking the first sacrificial material with one or more masks, (ii) removing the second sacrificial material, and (iii) filling the second section of the second source or drain trench with the second conductive material, thereby forming the second source or drain contact within the second source or drain trench.

15. The method of any one of claims 11 through 14, wherein prior to forming the first source or drain region, end sections of a plurality of bodies of semiconductor material are exposed through the first source or drain trench, and wherein forming the first source or drain region comprises:
epitaxially growing, within the first source or drain trench, a first portion of the first plurality of portions of the first source or drain region from an end section of a first body of the plurality of bodies of semiconductor material;
epitaxially growing, within the first source or drain trench, a second portion of the first plurality of portions of the first source or drain region from an end section of a second body of the plurality of bodies of semiconductor material; and
terminating the epitaxial growth of the first portion and the second portion, prior to merging of the first and second portion, thereby resulting in the first portion of the plurality of portions of the first source or drain region being discontinuous from the second portion of the plurality of portions of the first source or drain region.
